# EUROPEAN PATENT APPLICATION

(11) **EP 4 199 336 A1**
(43) Date of publication of application: **21.06.2023**
(21) Application number: 21881911.8
(22) Date of filing: 14.10.2021
(51) Int. Cl.: H02M 3/158

(54) **POWER SUPPLY SOURCE AND CURRENT SAMPLING METHOD**

(30) Priority: 23.10.2020 CN 202011147559
(71) Applicant: Huawei Digital Power Technologies Co., Ltd., Shenzhen, Guangdong 518043 (CN)
(72) Inventor: TANG, Jinwei, Shenzhen, Guangdong 518043 (CN); LI, Wenguang, Shenzhen, Guangdong 518043 (CN); DU, Changlei, Shenzhen, Guangdong 518043 (CN)
(74) Representative: Pfenning, Meinig & Partner mbB
(86) International application number: PCT/CN2021/123704
(87) International publication number: WO 2022/083493

(57) **Abstract**

This application provides a power supply and a current sampling method. The power supply includes an input power supply, a multiphase interleaved parallel converter, and a current sampling apparatus. The input power supply is configured to supply power to an input end of the multiphase interleaved parallel converter. The multiphase interleaved parallel converter includes at least two phases of converters that are connected in parallel. The current sampling apparatus is connected to a switching transistor in each phase of converter in the at least two phases of converters that are connected in parallel. The current sampling apparatus includes a first sampling resistor. The first sampling resistor is connected to the input end or an output end of the multiphase interleaved parallel converter. The at least two phases of converters that are connected in parallel include a first phase of converter. The current sampling apparatus is configured to determine an inductor current of the first phase of converter based on a first current that is of the first sampling resistor and that is collected at a first moment. A working circuit of the first phase of converter passes through the first sampling resistor at the first moment. In this application, circuit costs of the current sampling apparatus can be reduced, and applicability of the current sampling apparatus can be improved.

## Description

This application claims priority to Chinese Patent Application No. 202011147559.9, filed with the China National Intellectual Property Administration on October 23, 2020 and entitled "POWER SUPPLY AND CURRENT SAMPLING METHOD", which is incorporated herein by reference in its entirety.

### TECHNICAL FIELD

This application relates to the field of electronic circuit technologies, and in particular, to a power supply and a current sampling method.

### BACKGROUND

A multiphase interleaved parallel converter has a wide application prospect due to advantages such as high efficiency, a small volume, a high power density, and low costs. In a conventional technology, a current transformer collects a current of each phase of converter connected in series with each primary-side winding of the current transformer, and processes the current to obtain an inductor current of each phase of converter in a two-phase interleaved parallel converter. Because the current transformer used in this solution has a large volume and can sample only an alternating current, circuit costs are high and applicability is poor.

### SUMMARY

This application provides a power supply and a current sampling method. An inductor current of each phase of converter may be determined based on a current, at a specified moment, of a first sampling resistor connected to an input end or an output end of a multiphase interleaved parallel converter, so that circuit costs are low, and applicability is high.

According to a first aspect, this application provides a power supply, where the power supply includes an input power supply, a multiphase interleaved parallel converter, and a current sampling apparatus, the input power supply is configured to supply power to an input end of the multiphase interleaved parallel converter, the multiphase interleaved parallel converter includes at least two phases of converters that are connected in parallel, the current sampling apparatus is connected to a switching transistor in each phase of converter in the at least two phases of converters that are connected in parallel, the current sampling apparatus includes a first sampling resistor, the first sampling resistor is connected to the input end or an output end of the multiphase interleaved parallel converter, and the at least two phases of converters that are connected in parallel include a first phase of converter. The current sampling apparatus collects a first current of the first sampling resistor at a first moment, and determines an inductor current of the first phase of converter based on the first current of the first sampling resistor at the first moment, where a working circuit of the first phase of converter passes through the first sampling resistor at the first moment.

In this embodiment of this application, the current sampling apparatus determines the inductor current of the first phase of converter based on the current, at the first moment, of the first sampling resistor connected to the input end or the output end of the multiphase interleaved parallel converter. This reduces circuit costs of the current sampling apparatus, and increases direct current sampling support for the multiphase interleaved parallel converter, so that applicability is high.

With reference to the first aspect, in a first possible implementation, when determining that only the working circuit of the first phase of converter passes through the first sampling resistor at the first moment, the current sampling apparatus determines the first current of the first sampling resistor at the first moment as the inductor current of the first phase of converter.

With reference to the first aspect, in a second possible implementation, when the first sampling resistor is connected to the input end of the multiphase interleaved parallel converter, a second sampling resistor is connected to the output end of the multiphase interleaved parallel converter, and the current sampling apparatus determines that working circuits of all converters pass through the first sampling resistor at the first moment and a working circuit of a converter other than the first phase of converter passes through the second sampling resistor at the first moment, the current sampling apparatus collects a second current of the second sampling resistor at the first moment, and determines, as the inductor current of the first phase of converter, a difference between the first current of the first sampling resistor at the first moment and the second current of the second sampling resistor at the first moment.

In this embodiment of this application, when the first sampling resistor is connected to the input end of the multiphase interleaved parallel converter, the second sampling resistor is connected to the output end of the multiphase interleaved parallel converter, and neither the current of the first sampling resistor at the first moment nor the current of the second sampling resistor at the first moment is merely a working current of the first phase of converter, the current sampling apparatus determines the inductor current of the first phase of converter based on the difference between the current of the first sampling resistor at the first moment and the current of the second sampling resistor at the first moment.

With reference to the first aspect, in a third possible implementation, when the first sampling resistor is connected to the output end of the multiphase interleaved parallel converter, a second sampling resistor is connected to the input end of the multiphase interleaved parallel converter, and the current sampling apparatus determines that working circuits of all converters pass through the first sampling resistor at the first moment and a working circuit of a converter other than the first phase of converter passes through the second sampling resistor at the first moment, the current sampling apparatus collects a second current of the second sampling resistor at the first moment, and determines, as the inductor current of the first phase of converter, a difference between the first current of the first sampling resistor at the first moment and the second current of the second sampling resistor at the first moment.

In this embodiment of this application, when the first sampling resistor is connected to the output end of the multiphase interleaved parallel converter, the second sampling resistor is connected to the input end of the multiphase interleaved parallel converter, and neither the current of the first sampling resistor at the first moment nor the current of the second sampling resistor at the first moment is merely a working current of the first phase of converter, the current sampling apparatus determines the inductor current of the first phase of converter based on the difference between the current of the first sampling resistor at the first moment and the current of the second sampling resistor at the first moment.

With reference to the first aspect, in a fourth possible implementation, when the current sampling apparatus determines that working circuits of all converters pass through the first sampling resistor at the first moment, the current sampling apparatus collects a second current of the first sampling resistor at a second moment, and determines, the inductor current of the first phase of converter, a difference between the first current of the first sampling resistor at the first moment and the second current of the first sampling resistor at the second moment, where the working circuit of the first phase of converter does not pass through the first sampling resistor at the second moment, and a working circuit of another converter in the multiphase interleaved parallel converter passes through the first sampling resistor at the second moment.

In this embodiment of this application, when the working circuit of the first phase of converter passes through the first sampling resistor at the first moment, and the working circuit of the another converter also passes through the first sampling resistor at the first moment, the current sampling apparatus determines the inductor current of the first phase of converter based on the difference between the current of the first sampling resistor at the first moment and the current of the first sampling resistor at the second moment.

With reference to the first aspect, in a fifth possible implementation, the current sampling apparatus obtains an inductor current of each phase of converter in the multiphase interleaved parallel converter, and controls, based on the inductor current of each phase of converter, duration in which the switching transistor in each phase of converter is turned on or turned off.

In this embodiment of this application, after obtaining the inductor current of each phase of converter, the current sampling apparatus may calculate an average value of the inductor currents of all the converters, and adjust, by using the average value as a target inductor current, the duration in which the switching transistor in each phase of converter is turned on or turned off, to enable the inductor currents of all the phases of converters to be equal.

With reference to the first aspect, in a sixth possible implementation, the current sampling apparatus determines a circuit status value of the first phase of converter based on the inductor current of the first phase of converter, and controls, based on the circuit status value of the first phase of converter, duration in which a switching transistor in the first phase of converter is turned on or turned off.

In this embodiment of this application, the current sampling apparatus may calculate the circuit status value of the first phase of converter based on the inductor current of the first phase of converter. Herein, the circuit status value may include an input current value, an output current value, an input power value, or an output power value. When the circuit status value of the first phase of converter is greater than or equal to a preset circuit status value, the duration in which the switching transistor in the first phase of converter is turned on or turned off may be controlled to enable the first phase of converter to stop working, to implement circuit protection on the first phase of converter.

With reference to the first aspect, in a seventh possible implementation, the current sampling apparatus includes a sampling module and a processing module, where the sampling module collects the first current of the first sampling resistor; and the processing module obtains the first current of the first sampling resistor at the first moment, and determines the inductor current of the first phase of converter based on the first current of the first sampling resistor at the first moment.

With reference to the first aspect, in any possible implementation, the first phase of converter may be an H-bridge converter, a buck converter, a boost converter, or a buck-boost converter.

According to a second aspect, this application provides a current sampling method, where the current sampling method is applied to a power supply, the power supply includes an input power supply, a multiphase interleaved parallel converter, and a current sampling apparatus, the input power supply is configured to supply power to an input end of the multiphase parallel converter, the multiphase interleaved parallel converter includes at least two phases of converters that are connected in parallel, the current sampling apparatus is connected to a switching transistor in each phase of converter in the at least two phases of converters that are connected in parallel, the current sampling apparatus includes a first sampling resistor, the first sampling resistor is connected to the input end or an output end of the multiphase interleaved parallel converter, and the at least two phases of converters that are connected in parallel include a first phase of converter. In the method, the current sampling apparatus collects a first current of the first sampling resistor at a first moment at which a working circuit of the first phase of converter passes through the first sampling resistor, and determines an inductor current of the first phase of converter based on the first current of the first sampling resistor.

In this embodiment of this application, the current sampling apparatus determines the inductor current of the first phase of converter based on the current, at the first moment, of the first sampling resistor connected to the input end or the output end of the multiphase interleaved parallel converter. This reduces circuit costs of the current sampling apparatus, and increases direct current sampling support for the multiphase interleaved parallel converter, so that applicability is high.

With reference to the second aspect, in a first possible implementation, when determining, at the first moment, that only the working circuit of the first phase of converter passes through the first sampling resistor, the current sampling apparatus determines the first current of the first sampling resistor as the inductor current of the first phase of converter.

With reference to the second aspect, in a second possible implementation, when the first sampling resistor is connected to the input end of the multiphase interleaved parallel converter, and a second sampling resistor is connected to the output end of the multiphase interleaved parallel converter, the current sampling apparatus collects the first current of the first sampling resistor and a second current of the second sampling resistor at the first moment, and determines, as the inductor current of the first phase of converter, a difference between the first current of the first sampling resistor and the second current of the second sampling resistor, where working circuits of all converters pass through the first sampling resistor at the first moment, and a working circuit of a converter other than the first phase of converter passes through the second sampling resistor at the first moment.

In this embodiment of this application, when the first sampling resistor is connected to the input end of the multiphase interleaved parallel converter, the second sampling resistor is connected to the output end of the multiphase interleaved parallel converter, and neither the current of the first sampling resistor at the first moment nor the current of the second sampling resistor at the first moment is merely a working current of the first phase of converter, the current sampling apparatus determines the inductor current of the first phase of converter based on the difference between the current of the first sampling resistor at the first moment and the current of the second sampling resistor at the first moment.

With reference to the second aspect, in a third possible implementation, when the first sampling resistor is connected to the output end of the multiphase interleaved parallel converter, and a second sampling resistor is connected to the input end of the multiphase interleaved parallel converter, the current sampling apparatus collects the first current of the first sampling resistor and a second current of the second sampling resistor at the first moment, and determines, as the inductor current of the first phase of converter, a difference between the first current of the first sampling resistor and the second current of the second sampling resistor, where working circuits of all converters pass through the first sampling resistor at the first moment, and a working circuit of a converter other than the first phase of converter passes through the second sampling resistor at the first moment.

In this embodiment of this application, when the first sampling resistor is connected to the output end of the multiphase interleaved parallel converter, the second sampling resistor is connected to the input end of the multiphase interleaved parallel converter, and neither the current of the first sampling resistor at the first moment nor the current of the second sampling resistor at the first moment is merely a working current of the first phase of converter, the current sampling apparatus determines the inductor current of the first phase of converter based on the difference between the current of the first sampling resistor at the first moment and the current of the second sampling resistor at the first moment.

With reference to the second aspect, in a fourth possible implementation, the current sampling apparatus collects the first current of the first sampling resistor at the first moment, collects a second current of the first sampling resistor at a second moment, and determines, as the inductor current of the first phase of converter, a difference between the first current of the first sampling resistor and the second current of the first sampling resistor, where working circuits of all converters pass through the first sampling resistor at the first moment, the working circuit of the first phase of converter does not pass through the first sampling resistor at the second moment, and a working circuit of another converter passes through the first sampling resistor at the second moment.

In this embodiment of this application, when the working circuit of the first phase of converter passes through the first sampling resistor at the first moment, and the working circuit of the another converter also passes through the first sampling resistor at the first moment, the current sampling apparatus determines the inductor current of the first phase of converter based on the difference between the current of the first sampling resistor at the first moment and the current of the first sampling resistor at the second moment.

With reference to the second aspect, in a fifth possible implementation, the current sampling apparatus obtains an inductor current of each phase of converter in the multiphase interleaved parallel converter, and controls, based on the inductor current of each phase of converter, duration in which the switching transistor in each phase of converter is turned on or turned off.

In this embodiment of this application, after obtaining the inductor current of each phase of converter, the current sampling apparatus may calculate an average value of the inductor currents of all the converters, and adjust, by using the average value as a target inductor current, the duration in which the switching transistor in each phase of converter is turned on or turned off, to enable the inductor currents of all the phases of converters to be equal.

With reference to the second aspect, in a sixth possible implementation, the current sampling apparatus determines a circuit status value of the first phase of converter based on the inductor current of the first phase of converter, and controls, based on the circuit status value of the first phase of converter, duration in which a switching transistor in the first phase of converter is turned on or turned off.

In this embodiment of this application, the current sampling apparatus may calculate the circuit status value of the first phase of converter based on the inductor current of the first phase of converter. When the circuit status value of the first phase of converter is greater than or equal to a preset circuit status value, the duration in which the switching transistor in the first phase of converter is turned on or turned off may be controlled to enable the first phase of converter to stop working, to implement circuit protection on the first phase of converter.

With reference to the second aspect, in any possible implementation, the first phase of converter may be an H-bridge converter, a buck converter, a boost converter, or a buck-boost converter.

In this application, the inductor current of each phase of converter may be determined by using a current that is collected at a specified moment and that is of the first sampling resistor connected to the input end or the output end of the multiphase interleaved parallel converter, so that circuit costs of the current sampling apparatus are low, and applicability is high.

### BRIEF DESCRIPTION OF DRAWINGS

FIG. 1 is a schematic diagram of a structure of a power supply according to this application;
FIG. 2a is a schematic diagram of a structure of a power supply in which a two-phase interleaved parallel H-bridge converter is used according to this application;
FIG. 2b is a schematic diagram of a structure of a power supply in which a two-phase interleaved parallel buck converter is used according to this application;
FIG. 2c is a schematic diagram of a structure of a power supply in which a two-phase interleaved parallel boost converter is used according to this application;
FIG. 3 is a schematic diagram of a structure of a power supply in which a two-phase interleaved parallel buck-boost converter is used according to this application;
FIG. 4a is a schematic diagram of a structure of a power supply in which a three-phase interleaved parallel H-bridge converter is used according to this application;
FIG. 4b is a schematic diagram of a structure of a power supply in which a three-phase interleaved parallel buck converter is used according to this application;
FIG. 4c is a schematic diagram of a structure of a power supply in which a three-phase interleaved parallel boost converter is used according to this application; and
FIG. 5 is a schematic diagram of a structure of a power supply in which a three-phase interleaved parallel buck-boost converter is used according to this application.

### DESCRIPTION OF EMBODIMENTS

A current sampling apparatus in a power supply provided in this application may also be referred to as an inductor current sampling apparatus of a multiphase interleaved parallel converter. The current sampling apparatus of the multiphase interleaved parallel converter is applied to a plurality of electric energy conversion fields such as a new energy electric vehicle (for example, the multiphase interleaved parallel converter converts electric energy of a battery to supply power to a load motor in a forward process, and charges the battery in a backward process), a photovoltaic power generation field (for example, when light intensity is sufficient, the multiphase interleaved parallel converter charges a battery to store surplus electric energy emitted by a solar panel), and an energy storage system. This may be specifically determined based on an actual application scenario. This is not limited herein.

The multiphase interleaved parallel converter has a wide application prospect due to advantages such as high efficiency, a small volume, a high power density, and low costs. For a topology of a non-isolated power supply, a power inductor is a core component for performing power conversion by the non-isolated power supply. Therefore, for power conversion, it is extremely important to obtain an inductor current of each phase of converter in the multiphase interleaved parallel converter.

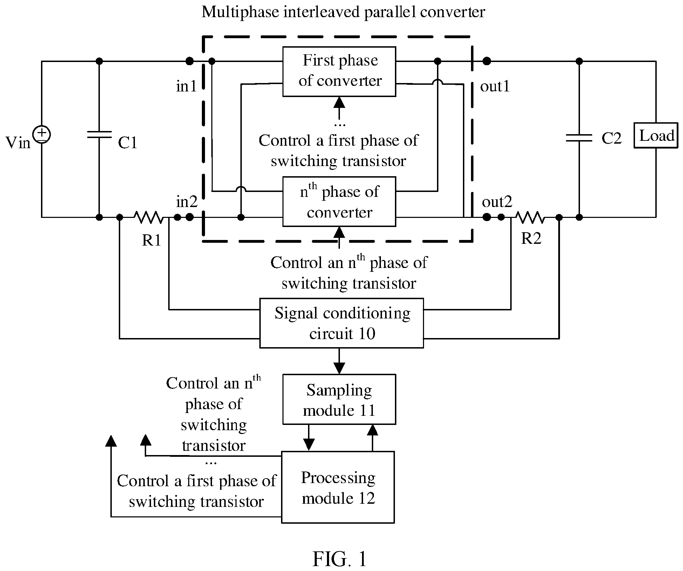

FIG. 1 is a schematic diagram of a structure of a power supply according to this application. As shown in FIG. 1, the power supply includes a direct current input power supply Vin, a multiphase interleaved parallel converter, and a current sampling apparatus. Two ends of the direct current input power supply Vin are respectively connected to a first input end in1 and a second input end in2 of the multiphase parallel converter, to supply power to the multiphase interleaved parallel converter. The multiphase interleaved parallel converter includes a first phase of converter to an n^{th} phase of converter, where n is an integer greater than or equal to 2. The first phase of converter to the n^{th} phase of converter are connected in parallel by using the first input end in1, the second input end in2, a first output end out1, and a second output end out2. The first output end out1 and the second output end out2 are connected to a load. In addition, the current sampling apparatus is connected to a switching transistor in each phase of converter in the multiphase interleaved parallel converter, to control duration in which the switching transistor in each phase of converter is turned on or turned off, so as to control a working status of each phase of converter. The current sampling apparatus includes a first sampling resistor. The first sampling resistor is connected to the input end or the output end of the multiphase interleaved parallel converter. The first sampling resistor may be R1 or R2. As shown in FIG. 1, R1 is disposed between in2 and Vin, and R2 is disposed between out2 and the load. In another optional embodiment, R1 may be disposed between in1 and Vin, and R2 may be disposed between out1 and the load.

Optionally, as shown in FIG. 1, a capacitor C1 may be further connected in parallel between in1 and in2, to filter out a spurious-wave component of the power supply, and smooth a pulsating direct current voltage. A capacitor C2 may be further connected in parallel between out1 and out2, to filter out a spurious-wave component of a current, so that voltages at two ends of the load are more stable.

The current sampling apparatus may determine an inductor current of each phase of converter based on a current that is of the first sampling resistor and that is collected at a specified moment. The current sampling apparatus may include a sampling module 11 and a processing module 12, and the sampling module 11 is connected to two ends of the first sampling resistor. In a specific implementation, the sampling module 11 may be an independent analog-to-digital converter (Analog-to-digital Converter, ADC), or may be an ADC module built in a microcontroller unit (Microcontroller Unit, MCU).

Optionally, as shown in FIG. 1, a signal conditioning circuit 10 may be further added before the sampling module 11, to amplify a current of the first sampling resistor and supply the amplified current to the sampling module 11, so as to improve resolution. In a specific implementation, the signal conditioning circuit 10 may be an operational amplifier or another amplification circuit.

In a possible implementation, the sampling module 11 is configured to continuously send a collected current of the first sampling resistor to the processing module 12. The processing module 12 is configured to: output a control signal (such as a PWM wave) to the switching transistor in each phase of converter to control the working status of each phase of converter, obtain a current of the first sampling resistor at a first moment from the current that is of the first sampling resistor and that is sent by the sampling module 11, and determine an inductor current of the first phase of converter based on the current of the first sampling resistor at the first moment. A working circuit of the first phase of converter passes through the first sampling resistor at the first moment.

In another possible implementation, the processing module 12 outputs a control signal to the switching transistor in each phase of converter to control the working status of each phase of converter, and sends a sampling control signal to the sampling module 11. The sampling module 11 collects a current of the first sampling resistor at a first moment based on the received sampling control signal, and returns, to the processing module 12, the current that is of the first sampling resistor and that is collected at the first moment. The processing module 12 determines an inductor current of the first phase of converter based on the current of the first sampling resistor at the first moment. A working circuit of the first phase of converter passes through the first sampling resistor at the first moment.

The first moment may be a specified moment in a time period in which a controllable switching transistor in the first phase of converter is turned on or turned off, for example, a midpoint moment and a median moment. The midpoint moment may be a middle moment in the foregoing time period. For example, if both a time period in which a controllable switching transistor Q1 in the first phase of converter is turned on and a time period in which a controllable switching transistor Q2 in the first phase of converter is turned off start from 09:10:00 and end at 09:10:20, the midpoint moment is 09:10:10. The median moment may be a moment corresponding to an inductor current value (*I*_{*L*max}+ *I*_{*L*min})/2 in the foregoing time period, where *I*_{*L*max} and *I*_{*L*min} are respectively a maximum inductor current value and a minimum inductor current value in the foregoing time period. For example, when there is only one median moment in the foregoing time period, in both the time period in which the controllable switching transistor Q1 in the first phase of converter is turned on and the time period in which the controllable switching transistor Q2 in the first phase of converter is turned off, if a moment corresponding to *I*_{*L*max} is 09:10:20, a moment corresponding to *I*_{*L*min} is 09:10:40, and the moment corresponding to (*I*_{*L*max}+ *I*_{*L*min}) / 2 is 09:10:25, the median moment is 09:10:25. In a subsequent embodiment, that the first moment is the midpoint moment in the time period in which the controllable switching transistor in the first phase of converter is turned on is used as an example for description in this application.

Based on the power supply shown in FIG. 1, this application further provides a current sampling method. In the method, the processing module 12 obtains a first current of the first sampling resistor at the first moment at which the working circuit of the first phase of converter passes through the first sampling resistor, and determines the inductor current of the first phase of converter based on the first current of the first sampling resistor.

For example, if only the working circuit of the first phase of converter passes through the first sampling resistor, there is a switching transistor in a turn-on state in the first phase of converter, an inductor in the first phase of converter is in a charging state, and a current that is of the first sampling resistor and that is obtained by the processing module 12 in the time period is a working current of the first phase of converter, namely, a charging current of the inductor in the first phase of converter. The inductor current of each phase of converter in this application may be an average current value of an inductor in each phase of converter in one charging/discharging period. The average current value of the inductor may be calculated by dividing, by one charging/discharging period, an area surrounded by a current curve of the inductor in the period and a time axis. For example, when a circuit in which the multiphase interleaved parallel converter is located is in a continuous conduction mode (Continuous Conduction Mode, CCM), in one charging/discharging period, an area surrounded by a current curve of the inductor in the first phase of converter and a time axis is a sum of areas of a first trapezoid and a second trapezoid. Short bases and long bases of the first trapezoid and the second trapezoid are *I*_{*L*min} and *I*_{*L*max}, a height of the first trapezoid is *T*₁, a height of the second trapezoid is *T*₂*,* and *T*₁+*T*₂=*T*, where *I*_{*L*min} and *I*_{*L*max} are respectively a maximum inductor current value and a minimum inductor current value in one charging/discharging period, and *T* is the charging/discharging period. In this case, an average current value of the inductor in the first phase of converter is (*I*_{*L*max}+*I*_{*L*min}) / 2 . It may be learned from the median line theorem of a trapezoid that an average current value of an inductor is equal to an inductor current value at a midpoint moment in a time period in which the inductor is in a charging state or a discharging state. In addition, whether the inductor is in a charging state or a discharging state depends on whether a controllable switching transistor in each phase of converter is in a turn-on state or turn-off state. Therefore, the processing module 12 may determine, as the inductor current value of the first phase of converter, a current value of the first sampling resistor at the midpoint moment in the time period in which the controllable switching transistor in the first phase of converter is turned on or turned off. In addition, when the circuit in which the multiphase interleaved parallel converter is located is in a boundary conduction mode (Boundary Conduction Mode, BCM), the foregoing conclusion is also applicable.

According to the power supply provided in the embodiments of this application and the current sampling method corresponding to the power supply, circuit costs of the current sampling apparatus are reduced, and direct current sampling support for the multiphase interleaved parallel converter is increased, so that applicability is high.

The power supply provided in this application and the current sampling method corresponding to the power supply may be applied to different application scenarios that are mainly classified into two application scenarios: current sharing and circuit protection.

In the current sharing scenario, the current sampling apparatus may calculate the inductor current of each phase of converter in the multiphase interleaved parallel converter based on the foregoing manner of calculating the inductor current of the first phase of converter, and control, based on the inductor current of each phase of converter, the duration in which the switching transistor in each phase of converter is turned on or turned off, to enable the inductor currents of all the phases of converters to be equal.

Specifically, it is assumed that the current sampling apparatus learns, through calculation, that the inductor current of the first phase of converter, an inductor current of the second phase of converter, ..., and an inductor current of the n^{th} phase of converter in the multiphase interleaved parallel converter are respectively *x*₁, *x*₂, ..., and *xₙ*. In this case, a target inductor current *x*=(*x*₁ + *x*₂ + ... + *xₙ*)/*n* is calculated based on the inductor current of each phase of converter. If *x*₁ > *x,* the current sampling apparatus shortens duration in which the switching transistor in the first phase of converter is turned on, or prolongs duration in which the switching transistor in the first phase of converter is turned off, until *x*₁=*x*. If *x*₁ < *x*, the current sampling apparatus prolongs duration in which the switching transistor in the first phase of converter is turned on, or shortens duration in which the switching transistor in the first phase of converter is turned off, until *x*₁=*x*. The inductor currents of all the phases of converters can be equal based on the foregoing manner.

In the circuit protection scenario, the current sampling apparatus determines a circuit status value of the first phase of converter based on the inductor current of the first phase of converter, and controls, based on the circuit status value of the first phase of converter, duration in which the switching transistor in the first phase of converter is turned on or turned off. The circuit status value may include an input current value, an output current value, an input power value, or an output power value.

Specifically, if the first phase of converter is a buck converter or the first phase of converter is an H-bridge converter and works in a buck mode, the current sampling apparatus determines the inductor current value of the first phase of converter as an output current value of the first phase of converter. If the output current value of the first phase of converter is greater than or equal to an output current threshold, the current sampling apparatus controls, to be 0, the duration in which the switching transistor in the first phase of converter is turned on, or controls, to be an entire period T, the duration in which the switching transistor in the first phase of converter is turned off, so that the first phase of converter stops working, to implement output overcurrent protection on the first phase of converter. Further, after determining the inductor current value of the first phase of converter as the output current value of the first phase of converter, the current sampling apparatus may obtain an output voltage of the first phase of converter by using a voltage sampling circuit, and calculate a product of the output current value of the first phase of converter and the output voltage of the first phase of converter to obtain an output power value of the first phase of converter. If the output power value of the first phase of converter is greater than or equal to an output power threshold, the first phase of converter may be controlled, in the foregoing manner, to stop working, to implement output overpower protection on the first phase of converter.

If the first phase of converter is a boost converter or the first phase of converter is an H-bridge converter and works in a boost mode, the current sampling apparatus determines the inductor current value of the first phase of converter as an input current value of the first phase of converter. If the input current value of the first phase of converter is greater than or equal to an input current threshold, the current sampling apparatus controls, to be 0, the duration in which the switching transistor in the first phase of converter is turned on, or controls, to be an entire period T, the duration in which the switching transistor in the first phase of converter is turned off, so that the first phase of converter stops working, to implement input overcurrent protection on the first phase of converter. Further, after determining the inductor current value of the first phase of converter as the input current value of the first phase of converter, the current sampling apparatus may obtain an input voltage of the first phase of converter by using a voltage sampling circuit, and calculate a product of the input current value of the first phase of converter and the input voltage of the first phase of converter to obtain an input power value of the first phase of converter. If the input power value of the first phase of converter is greater than or equal to an input power threshold, the first phase of converter may be controlled, in the foregoing manner, to stop working, to implement input overpower protection on the first phase of converter.

If the first phase of converter is a buck-boost converter or the first phase of converter is an H-bridge converter and working in a buck-boost mode, as shown in FIG. 1, when the first sampling resistor is R1, the current sampling apparatus determines the inductor current value of the first phase of converter as an output current value of the first phase of converter. If the output current value of the first phase of converter is greater than or equal to an output current threshold, the first phase of converter is controlled, in the foregoing manner, to stop working, to implement output overcurrent protection on the first phase of converter. Further, after determining the inductor current value of the first phase of converter as the output current value of the first phase of converter, the current sampling apparatus obtains an output voltage of the first phase of converter, to obtain an output power value of the first phase of converter. If the output power value of the first phase of converter is greater than or equal to an output power threshold, the first phase of converter may be controlled, in the foregoing manner, to stop working, to implement output overpower protection on the first phase of converter. When the first sampling resistor is R2, the current sampling apparatus determines the inductor current value of the first phase of converter as an input current value of the first phase of converter. If the input current value of the first phase of converter is greater than or equal to an input current threshold, the first phase of converter is controlled, in the foregoing manner, to stop working, to implement input overcurrent protection on the first phase of converter. Further, after determining the inductor current value of the first phase of converter as the input current value of the first phase of converter, the current sampling apparatus obtains an input voltage of the first phase of converter, to obtain an input power value of the first phase of converter. If the input power value of the first phase of converter is greater than or equal to an input power threshold, the first phase of converter may be controlled, in the foregoing manner, to stop working, to implement input overpower protection on the first phase of converter.

In a specific implementation, a quantity n of converters that are connected in parallel in FIG. 1 may be determined based on an actual application scenario. This is not limited herein. In addition, the schematic diagram of the structure in FIG. 1 is a schematic diagram in which some components of a multiphase parallel converter are connected. The multiphase parallel converter may further include more components. A manner in which the components are connected may be set based on a converter function required in an actual application scenario. This is not limited herein.

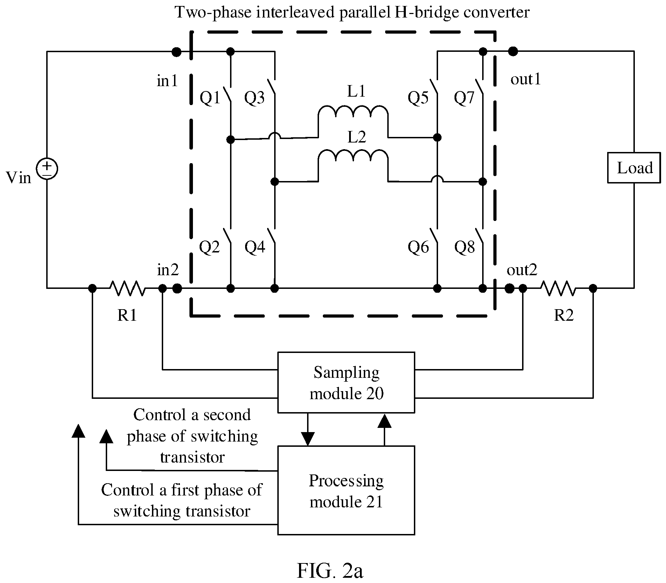

For example, FIG. 2a is a schematic diagram of a structure of a power supply in which a two-phase interleaved parallel H-bridge converter is used according to this application. As shown in FIG. 2a, the power supply includes Vin, a two-phase interleaved parallel H-bridge converter, and a current sampling apparatus. The two-phase interleaved parallel H-bridge converter includes a first phase of H-bridge converter and a second phase of H-bridge converter. The first phase of H-bridge converter includes switching transistors Q1, Q2, Q5, and Q6, and a power inductor L1. The second phase of H-bridge converter includes switching transistors Q3, Q4, Q7, and Q8, and a power inductor L2. The two phases of H-bridge converters are connected in parallel by using in1, in2, out1, and out2. In addition, the two-phase interleaved parallel H-bridge converter is connected to a first sampling resistor, and the first sampling resistor may be R1 or R2. In other words, the current sampling apparatus in this embodiment may include R1/R2 or both R1 and R2. In addition, the current sampling apparatus in this embodiment may further include a sampling module 20 and a processing module 21.

Q1 to Q8 may be switching transistors including but not limited to a MOS transistor, an IGBT, a diode, or a bipolar transistor. L1 and L2 may be independent inductors, or may be a two-phase integrated inductor.

The H-bridge converter works in a buck mode:
The processing module 21 controls Q5 and Q7 to be always turned on, controls Q6 and Q8 to be always turned off, and separately outputs, to Q1 to Q4, control signals whose periods are 1/f. In addition, control signals output to Q1 and Q3 have a phase difference of 180°, and control signals output to Q2 and Q4 have a phase difference of 180°, where f is a turn-on/turn-off frequency of a switching transistor, so that Q1 to Q4 are turned on or turned off based on the turn-on/turn-off frequency.

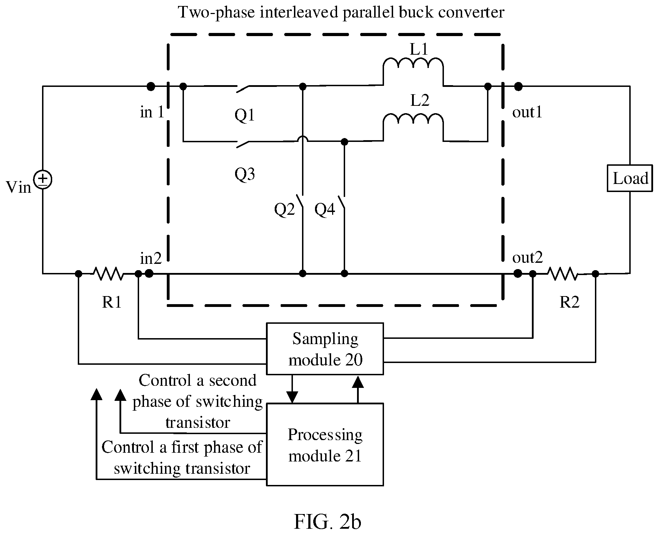

When the H-bridge converter works in the buck mode, the power supply in which the two-phase interleaved parallel H-bridge converter is used may be simplified as a power supply, shown in FIG. 2b, in which a two-phase interleaved parallel buck converter is used. As shown in FIG. 2b, the power supply includes Vin, a two-phase interleaved parallel buck converter, and a current sampling apparatus. The two-phase interleaved parallel buck converter includes a first phase of buck converter and a second phase of buck converter. The first phase of buck converter includes switching transistors Q1 and Q2, and a power inductor L1. The second phase of buck converter includes switching transistors Q3 and Q4, and a power inductor L2. The two phases of buck converters are connected in parallel by using in1, in2, out1, and out2. In addition, the two-phase interleaved parallel buck converter is connected to a first sampling resistor, and the first sampling resistor may be R1 or R2. In other words, the current sampling apparatus in this embodiment may include R1 or both R1 and R2. In addition, the current sampling apparatus in this embodiment may further include a sampling module 20 and a processing module 21. The processing module 21 is configured to separately output, to Q1 and Q3, control signals whose periods are 1/f and that have a phase difference of 180°.

In an implementation, the sampling module 20 is configured to collect a current of the first sampling resistor R1. The processing module 21 is configured to: obtain a current of R1 at a first moment, and determine an inductor current of the first phase of buck converter based on the current of R1 at the first moment.

Specifically, in a time period in which Q1 is turned on, L1 in the first phase of buck converter is in a charging state, and a current flowing out of a positive electrode of Vin arrives at a load through Q1 and L1, and then arrives at a negative electrode of Vin from the load through R1, to form a working circuit of the first phase of buck converter. Vin stores energy for L1 by using the working circuit of the first phase of buck converter. In the time period in which Q1 is turned on, there is a time segment in which Q3 is in a turn-off state and Q4 is in a turn-on state. The time segment includes a midpoint moment in the time period in which Q1 is turned on. L2 in the second phase of buck converter is in a discharging state, and energy stored in L2 may be supplied to the load by using a working circuit that is of the second phase of buck converter and that is formed by L2 and Q4. In other words, the working circuit of the first phase of buck converter passes through R1 at the first moment, and the working circuit of the second phase of buck converter does not pass through R1 at the first moment. The processing module 21 may obtain the current of R1 at the first moment, and determine the current value of R1 at the first moment as the inductor current value of the first phase of buck converter. The first moment may be the midpoint moment in the time period in which Q1 is turned on.

Similarly, it may be learned that, if the working circuit of the first phase of buck converter does not pass through R1 at the first moment, and the working circuit of the second phase of buck converter passes through R1 at the first moment, the processing module 21 may obtain the current of R1 at the first moment, and determine the current value of R1 at the first moment as an inductor current value of the second phase of buck converter. The first moment may be a midpoint moment in a time period in which Q3 is turned on.

Based on the foregoing power supply, this application further provides a current sampling method, including:
When determining, at a first moment, that a working circuit of another converter in a multiphase interleaved parallel converter does not pass through a first sampling resistor, the processing module 21 determines a first current of the first sampling resistor as an inductor current of a first phase of converter. The working circuit of the first phase of converter passes through the first sampling resistor at the first moment, and the first sampling resistor is connected to an input end of the multiphase interleaved parallel converter.

In another implementation, the sampling module 20 is configured to collect a current of the first sampling resistor R2 and a current of a second sampling resistor R1. The processing module 21 is configured to: obtain a current of R1 at a first moment and a current of R2 at the first moment, and determine an inductor current of the first phase of buck converter based on a difference between the current of R2 at the first moment and the current of R1 at the first moment.

Specifically, in a time period in which Q2 is turned on, L1 in the first phase of buck converter is in a discharging state, and energy stored in L1 may be supplied to a load by using a working circuit that is of the first phase of buck converter and that is formed by L1, R2, and Q2. In the time period in which Q2 is turned on, there is a time segment in which Q4 is in a turn-off state and Q3 is in a turn-on state. The time segment includes a midpoint moment in the time period in which Q2 is turned on. L2 in the second phase of buck converter is in a charging state, and a current flowing out of a positive electrode of Vin arrives at the load through Q3 and L2, and then arrives at a negative electrode of Vin from the load through R2 and R1, to form a working circuit of the second phase of buck converter. Vin stores energy for L2 by using the working circuit of the second phase of buck converter. In other words, the working circuits of both the first phase of buck converter and the second phase of buck converter pass through R2 at the first moment, and the working circuit of the second phase of buck converter passes through R1 at the first moment. The processing module 21 may obtain the current value of R2 at the first moment and the current value of R1 at the first moment, and determine, as the inductor current value of the first phase of buck converter, the difference between the current value of R2 at the first moment and the current value of R1 at the first moment. The first moment may be the midpoint moment in the time period in which Q2 is turned on.

Similarly, it may be learned that, if the working circuits of both the first phase of buck converter and the second phase of buck converter pass through R2 at the first moment, and the working circuit of the first phase of buck converter passes through R1 at the first moment, the processing module 21 may obtain the current value of R2 at the first moment and the current value of R1 at the first moment, and determine, as an inductor current value of the second phase of buck converter, the difference between the current value of R2 at the first moment and the current value of R1 at the first moment. The first moment may be a midpoint moment in a time period in which Q4 is turned on.

Based on the foregoing power supply, this application further provides a current sampling method, including:
When determining, at a first moment, that working circuits of all converters in a multiphase interleaved parallel converter pass through a first sampling resistor, the processing module 21 obtains a first current of the first sampling resistor. The first sampling resistor is connected to an output end of the multiphase interleaved parallel converter. The processing module 21 obtains a second current of a second sampling resistor at the first moment. A working circuit of another converter in the multiphase interleaved parallel converter passes through the second sampling resistor at the first moment, and the second sampling resistor is connected to an input end of the multiphase interleaved parallel converter. The processing module 21 determines, as an inductor current of a first phase of converter, a difference between the first current of the first sampling resistor and the second current of the second sampling resistor.

The H-bridge converter works in a boost mode:
The processing module 21 controls Q1 and Q3 to be always turned on, controls Q2 and Q4 to be always turned off, and separately outputs, to Q5, Q6, Q7, and Q8, control signals whose periods are 1/f. In addition, control signals output to Q5 and Q7 have a phase difference of 180°, and control signals output to Q6 and Q8 have a phase difference of 180°, where f is a turn-on/turn-off frequency of a switching transistor, so that Q5, Q6, Q7, and Q8 are turned on or turned off based on the turn-on/turn-off frequency.

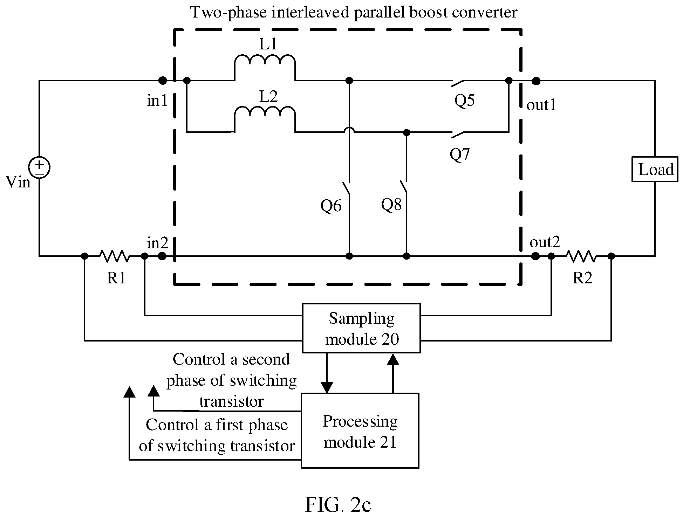

When the H-bridge converter works in the boost mode, the power supply in which the two-phase interleaved parallel H-bridge converter is used may be simplified as a power supply, shown in FIG. 2c, in which a two-phase interleaved parallel boost converter is used. As shown in FIG. 2c, the power supply includes Vin, a two-phase interleaved parallel boost converter, and a current sampling apparatus. The two-phase interleaved parallel boost converter includes a first phase of boost converter and a second phase of boost converter. The first phase of boost converter includes switching transistors Q5 and Q6, and a power inductor L1. The second phase of boost converter includes switching transistors Q7 and Q8, and a power inductor L2. The two phases of boost converters are connected in parallel by using in1, in2, out1, and out2. In addition, the two-phase interleaved parallel boost converter is connected to a first sampling resistor, and the first sampling resistor may be R1 or R2. In other words, the current sampling apparatus in this embodiment may include R2 or both R1 and R2. In addition, the current sampling apparatus in this embodiment may further include a sampling module 20 and a processing module 21. The processing module 21 is configured to separately output, to Q6 and Q8, control signals whose periods are 2πf and that have a phase difference of 180°.

In an implementation, the sampling module 20 is configured to collect a current of the first sampling resistor R2. The processing module 21 is configured to: obtain a current of R2 at a first moment, and determine an inductor current of the first phase of boost converter based on the current of R2 at the first moment.

Specifically, in a time period in which Q5 is turned on, L1 in the first phase of boost converter is in a discharging state, and a current flowing out of a positive electrode of Vin arrives at Q5 through L1, and then arrives at a negative electrode of Vin from Q5 through a load and R2, to form a working circuit of the first phase of boost converter. Vin supplies energy to the load by using the working circuit of the first phase of boost converter. In the time period in which Q5 is turned on, there is a time segment in which Q7 is in a turn-off state and Q8 is in a turn-on state. The time segment includes a midpoint moment in the time period in which Q5 is turned on. L2 in the second phase of boost converter is in a charging state, and the current flowing out of the positive electrode of Vin arrives at the negative electrode of Vin from L2 through Q8, to form a working circuit of the second phase of boost converter. Vin stores energy for L2 by using the working circuit of the second phase of boost converter. In other words, the working circuit of the first phase of boost converter passes through R2 at the first moment, and the working circuit of the second phase of boost converter does not pass through R2 at the first moment. The processing module 21 may obtain the current of R2 at the first moment, and determine the current value of R2 at the first moment as the inductor current value of the first phase of boost converter. The first moment may be the midpoint moment in the time period in which Q5 is turned on.

Similarly, it may be learned that, if the working circuit of the first phase of boost converter does not pass through R2 at the first moment, and the working circuit of the second phase of boost converter passes through R2 at the first moment, the processing module 21 may obtain the current of R2 at the first moment, and determine the current value of R2 at the first moment as an inductor current value of the second phase of boost converter. The first moment may be a midpoint moment in a time period in which Q7 is turned on.

Based on the foregoing power supply, this application further provides a current sampling method, including:
When determining, at a first moment, that a working circuit of another converter in a multiphase interleaved parallel converter does not pass through a first sampling resistor, the processing module 21 determines a first current of the first sampling resistor as an inductor current of a first phase of converter. The working circuit of the first phase of converter passes through the first sampling resistor at the first moment, and the first sampling resistor is connected to an output end of the multiphase interleaved parallel converter.

In another implementation, the sampling module 20 is configured to collect a current of the first sampling resistor R1 and a current of a second sampling resistor R2. The processing module 21 is configured to: obtain a current of R1 at a first moment and a current of R2 at the first moment, and determine an inductor current of the first phase of boost converter based on a difference between the current of R1 at the first moment and the current of R2 at the first moment.

Specifically, in a time period in which Q6 is turned on, L1 in the first phase of boost converter is in a charging state, and a current flowing out of a positive electrode of Vin arrives at Q6 through L1, and then arrives at a negative electrode of Vin from Q6 through R1, to form a working circuit of the first phase of boost converter. Vin stores energy for L1 by using the working circuit of the first phase of boost converter. In the time period in which Q6 is turned on, there is a time segment in which Q8 is in a turn-off state and Q7 is in a turn-on state. The time segment includes a midpoint moment in the time period in which Q6 is turned on. L2 in the second phase of boost converter is in a discharging state, and the current flowing out of the positive electrode of Vin arrives at Q7 through L2, and then arrives at the negative electrode of Vin from Q7 through R2 and R1, to form a working circuit of the second phase of boost converter. Vin supplies energy to L2 by using the working circuit of the second phase of boost converter. In other words, the working circuits of both the first phase of boost converter and the second phase of boost converter pass through R1 at the first moment, and the working circuit of the second phase of boost converter passes through R2 at the first moment. The processing module 21 may obtain the current value of R1 at the first moment and the current value of R2 at the first moment, and determine, as the inductor current value of the first phase of boost converter, the difference between the current value of R1 at the first moment and the current value of R2 at the first moment. The first moment may be the midpoint moment in the time period in which Q6 is turned on.

Similarly, it may be learned that, if the working circuits of both the first phase of boost converter and the second phase of boost converter pass through R1 at the first moment, and the working circuit of the first phase of boost converter passes through R2 at the first moment, the processing module 21 may obtain the current value of R1 at the first moment and the current value of R2 at the first moment, and determine, as an inductor current value of the second phase of boost converter, the difference between the current value of R1 at the first moment and the current value of R2 at the first moment. The first moment may be a midpoint moment in a time period in which Q8 is turned on.

Based on the foregoing power supply, this application further provides a current sampling method, including:
When determining, at a first moment, that working circuits of all converters in a multiphase interleaved parallel converter pass through a first sampling resistor, the processing module 21 obtains a first current of the first sampling resistor. The first sampling resistor is connected to an input end of the multiphase interleaved parallel converter. The processing module 21 obtains a second current of a second sampling resistor at the first moment. A working circuit of another converter in the multiphase interleaved parallel converter passes through the second sampling resistor at the first moment, and the second sampling resistor is connected to an output end of the multiphase interleaved parallel converter. The processing module 21 determines, as an inductor current of a first phase of converter, a difference between the first current of the first sampling resistor and the second current of the second sampling resistor.

Still refer to FIG. 2a. The H-bridge converter works in a buck-boost mode:
The processing module 21 separately outputs, to the switching transistors Q1 to Q8, control signals whose periods are 1/f. In addition, control signals output to Q1 and Q6 have a phase difference of 0°, control signals output to Q2 and Q5 have a phase difference of 0°, control signals output to Q3 and Q8 have a phase difference of 0°, control signals output to Q4 and Q7 have a phase difference of 0°, control signals output to Q1 and Q3 have a phase difference of 180°, control signals output to Q2 and Q4 have a phase difference of 180°, control signals output to Q5 and Q7 have a phase difference of 180°, and control signals output to Q6 and Q8 have a phase difference of 180°, where f is a tum-on/tum-off frequency of a switching transistor, so that Q1 to Q8 are turned on or turned off based on the turn-on/turn-off frequency.

In an implementation, the sampling module 20 is configured to collect a current of the first sampling resistor R1. The processing module 21 is configured to: obtain a current of R1 at a first moment, and determine an inductor current of the first phase of H-bridge converter based on the current of R1 at the first moment.

Specifically, in a time period in which Q1 and Q6 are turned on, L1 in the first phase of H-bridge converter is in a charging state, and a current flowing out of a positive electrode of Vin arrives at L1 through Q1, and then arrives at a negative electrode of Vin from L1 through Q6 and R1, to form a working circuit of the first phase of H-bridge converter. Vin stores energy for L1 by using the working circuit of the first phase of H-bridge converter. In the time period in which Q1 and Q6 are turned on, there is a time segment in which Q3 and Q8 are in a turn-off state and Q4 and Q7 are in a turn-on state. The time segment includes a midpoint moment in the time period in which Q1 and Q6 are turned on. L2 in the second phase of H-bridge converter is in a discharging state, and energy stored in L2 may be supplied to a load by using a working circuit that is of the second phase of H-bridge converter and that is formed by L2, Q7, and Q4. In other words, the working circuit of the first phase of H-bridge converter passes through R1 at the first moment, and the working circuit of the second phase of H-bridge converter does not pass through R1 at the first moment. The processing module 21 may obtain the current of R1 at the first moment, and determine the current value of R1 at the first moment as the inductor current value of the first phase of H-bridge converter. The first moment may be the midpoint moment in the time period in which Q1 and Q6 are turned on.

Similarly, it may be learned that, if the working circuit of the first phase of H-bridge converter does not pass through R1 at the first moment, and the working circuit of the second phase of H-bridge converter passes through R1 at the first moment, the processing module 21 may obtain the current of R1 at the first moment, and determine the current value of R1 at the first moment as an inductor current value of the second phase of H-bridge converter. The first moment may be a midpoint moment in a time period in which Q3 and Q8 are turned on.

Based on the foregoing power supply, this application further provides a current sampling method, including:
When determining, at a first moment, that a working circuit of another converter in a multiphase interleaved parallel converter does not pass through a first sampling resistor, the processing module 21 determines a first current of the first sampling resistor as an inductor current of a first phase of converter. The working circuit of the first phase of converter passes through the first sampling resistor at the first moment, and the first sampling resistor is connected to an input end of the multiphase interleaved parallel converter.

In another implementation, the sampling module 20 is configured to collect a current of the first sampling resistor R2. The processing module 21 is configured to: obtain a current of R2 at a first moment, and determine an inductor current of the first phase of H-bridge converter based on the current of R2 at the first moment.

Specifically, in a time period in which Q2 and Q5 are turned on, L1 in the first phase of H-bridge converter is in a discharging state, and energy stored in L1 may be supplied to a load by using a working circuit that is of the first phase of H-bridge converter and that is formed by L1, Q5, R2, and Q2. In the time period in which Q2 and Q5 are turned on, there is a time segment in which Q4 and Q7 are in a turn-off state and Q3 and Q8 are in a turn-on state. The time segment includes a midpoint moment in the time period in which Q2 and Q5 are turned on. L2 in the second phase of H-bridge converter is in a charging state, and a current flowing out of a positive electrode of Vin arrives at L2 through Q3, and then arrives at a negative electrode of Vin from L2 through Q8, to form a working circuit of the second phase of H-bridge converter. Vin stores energy for L2 by using the working circuit of the second phase of H-bridge converter. In other words, the working circuit of the first phase of H-bridge converter passes through R2 at the first moment, and the working circuit of the second phase of H-bridge converter does not pass through R2 at the first moment. The processing module 21 may obtain the current of R2 at the first moment, and determine the current value of R2 at the first moment as the inductor current value of the first phase of H-bridge converter. The first moment may be the midpoint moment in the time period in which Q2 and Q5 are turned on.

Similarly, it may be learned that, if the working circuit of the first phase of H-bridge converter does not pass through R2 at the first moment, and the working circuit of the second phase of H-bridge converter passes through R2 at the first moment, the processing module 21 may obtain the current of R2 at the first moment, and determine the current value of R2 at the first moment as an inductor current value of the second phase of H-bridge converter. The first moment may be a midpoint moment in a time period in which Q4 and Q7 are turned on.

Based on the foregoing power supply, this application further provides a current sampling method, including:
When determining, at a first moment, that a working circuit of another converter in a multiphase interleaved parallel converter does not pass through a first sampling resistor, the processing module 21 determines a first current of the first sampling resistor as an inductor current of a first phase of converter. The working circuit of the first phase of converter passes through the first sampling resistor at the first moment, and the first sampling resistor is connected to an output end of the multiphase interleaved parallel converter.

In this embodiment of this application, when determining that only the working circuit of the first phase of H-bridge converter passes through the first sampling resistor R1 or R2 at the first moment, the processing module 21 determines the current value of the first sampling resistor at the first moment as the inductor current value of the first phase of H-bridge converter. When neither the current of the first sampling resistor R1 at the first moment nor the current of the second sampling resistor R2 at the first moment is merely a working current of the first phase of H-bridge converter, the processing module 21 determines, as the inductor current value of the first phase of H-bridge converter, the difference between the current value of R1 at the first moment and the current value of R2 at the first moment. Alternatively, when neither the current of the first sampling resistor R2 at the first moment nor the current of the second sampling resistor R1 at the first moment is merely a working current of the first phase of H-bridge converter, the processing module 21 determines, as the inductor current value of the first phase of H-bridge converter, the difference between the current value of R2 at the first moment and the current value of R1 at the first moment.

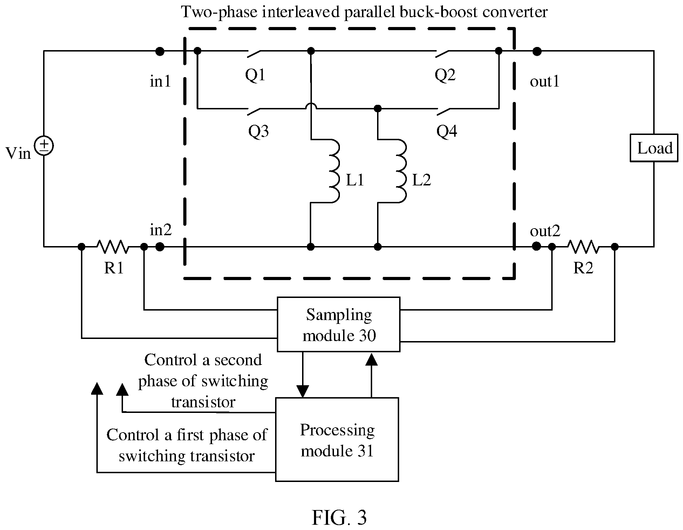

For example, FIG. 3 is a schematic diagram of a structure of a power supply in which a two-phase interleaved parallel buck-boost converter is used according to this application. As shown in FIG. 3, the power supply includes Vin, a two-phase interleaved parallel buck-boost converter, and a current sampling apparatus. The two-phase interleaved parallel buck-boost converter includes a first phase of buck-boost converter and a second phase of buck-boost converter. The first phase of buck-boost converter includes switching transistors Q1 and Q2, and a power inductor L1. The second phase of buck-boost converter includes switching transistors Q3 and Q4, and a power inductor L2. The two phases of buck-boost converters are connected in parallel by using in1, in2, out1, and out2. In addition, the two-phase interleaved parallel buck-boost converter is connected to a first sampling resistor, and the first sampling resistor may be R1 or R2. In other words, the current sampling apparatus in this embodiment may include R1/R2. In addition, the current sampling apparatus in this embodiment may further include a sampling module 30 and a processing module 31. The processing module 31 is configured to separately output, to Q1 and Q3, control signals whose periods are 1/f and that have a phase difference of 180°, where f is a turn-on/turn-off frequency of a switching transistor.

Q1 to Q4 may be switching transistors including but not limited to a MOS transistor, an IGBT, a diode, or a bipolar transistor. L1 and L2 may be independent inductors, or may be a two-phase integrated inductor.

In an implementation, the sampling module 30 is configured to collect a current of the first sampling resistor R1. The processing module 31 is configured to: obtain a current of R1 at a first moment, and determine an inductor current of the first phase of buck-boost converter based on the current of R1 at the first moment.

Specifically, in a time period in which Q1 is turned on, L1 in the first phase of buck-boost converter is in a charging state, and a current flowing out of a positive electrode of Vin arrives at L1 through Q1, and then arrives at a negative electrode of Vin from L1 through R1, to form a working circuit of the first phase of H-bridge converter. Vin stores energy for L1 by using the working circuit of the first phase of H-bridge converter. In the time period in which Q1 is turned on, there is a time segment in which Q3 is in a turn-off state and Q4 is in a turn-on state. The time segment includes a midpoint moment in the time period in which Q1 is turned on. L2 in the second phase of buck-boost converter is in a discharging state, and energy stored in L2 may be supplied to a load by using a working circuit that is of the second phase of buck-boost converter and that is formed by L2 and Q4. In other words, the working circuit of the first phase of buck-boost converter passes through R1 at the first moment, and the working circuit of the second phase of buck-boost converter does not pass through R1 at the first moment. The processing module 31 may obtain the current of R1 at the first moment, and determine the current value of R1 at the first moment as the inductor current value of the first phase of buck-boost converter. The first moment may be the midpoint moment in the time period in which Q1 is turned on.

Similarly, it may be learned that, if the working circuit of the first phase of buck-boost converter does not pass through R1 at the first moment, and the working circuit of the second phase of buck-boost converter passes through R1 at the first moment, the processing module 31 may obtain the current of R1 at the first moment, and determine the current value of R1 at the first moment as an inductor current value of the second phase of buck-boost converter. The first moment may be a midpoint moment in a time period in which Q3 is turned on.

Based on the foregoing power supply, this application further provides a current sampling method, including:
When determining, at a first moment, that a working circuit of another converter in a multiphase interleaved parallel converter does not pass through a first sampling resistor, the processing module 31 determines a first current of the first sampling resistor as an inductor current of a first phase of converter. The working circuit of the first phase of converter passes through the first sampling resistor at the first moment, and the first sampling resistor is connected to an input end of the multiphase interleaved parallel converter.

In another implementation, the sampling module 30 is configured to collect a current of the first sampling resistor R2. The processing module 31 is configured to: obtain a current of R2 at a first moment, and determine an inductor current of the first phase of buck-boost converter based on the current of R2 at the first moment.

Specifically, in a time period in which Q2 is turned on, L1 in the first phase of buck-boost converter is in a discharging state, and energy stored in L1 may be supplied to a load by using a working circuit that is of the first phase of buck-boost converter and that is formed by L1, Q2, and R2. In the time period in which Q2 is turned on, there is a time segment in which Q4 is in a turn-off state and Q3 is in a turn-on state. The time segment includes a midpoint moment in the time period in which Q2 is turned on. L2 in the second phase of buck-boost converter is in a charging state, and a current flowing out of a positive electrode of Vin arrives at L2 through Q3, and then arrives at a negative electrode of Vin from L2, to form a working circuit of the second phase of H-bridge converter. Vin stores energy for L2 by using the working circuit of the second phase of H-bridge converter. In other words, the working circuit of the first phase of buck-boost converter passes through R2 at the first moment, and the working circuit of the second phase of buck-boost converter does not pass through R2 at the first moment. The processing module 31 may obtain the current of R2 at the first moment, and determine the current value of R2 at the first moment as the inductor current value of the first phase of buck-boost converter. The first moment may be the midpoint moment in the time period in which Q2 is turned on.

Similarly, it may be learned that, if the working circuit of the first phase of buck-boost converter does not pass through R2 at the first moment, and the working circuit of the second phase of buck-boost converter passes through R2 at the first moment, the processing module 31 may obtain the current of R2 at the first moment, and determine the current value of R2 at the first moment as an inductor current value of the second phase of buck-boost converter. The first moment may be a midpoint moment in a time period in which Q4 is turned on.

Based on the foregoing power supply, this application further provides a current sampling method, including:
When determining, at a first moment, that a working circuit of another converter in a multiphase interleaved parallel converter does not pass through a first sampling resistor, the processing module 31 determines a first current of the first sampling resistor as an inductor current of a first phase of converter. The working circuit of the first phase of converter passes through the first sampling resistor at the first moment, and the first sampling resistor is connected to an output end of the multiphase interleaved parallel converter.

In this embodiment of this application, when determining that only the working circuit of the first phase of buck-boost converter passes through the first sampling resistor R1 or R2 at the first moment, the processing module 31 determines the current value of the first sampling resistor at the first moment as the inductor current value of the first phase of buck-boost converter.

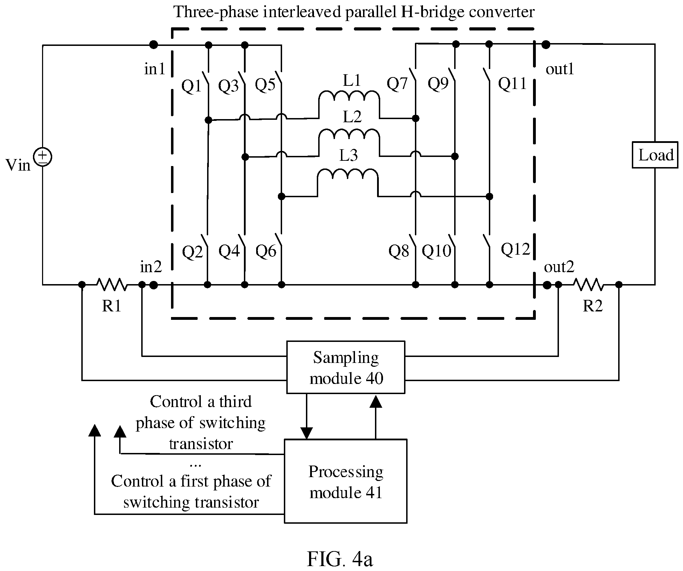

For example, FIG. 4a is a schematic diagram of a structure of a power supply in which a three-phase interleaved parallel H-bridge converter is used according to this application. As shown in FIG. 4a, the power supply includes Vin, a three-phase interleaved parallel H-bridge converter, and a current sampling apparatus. The three-phase interleaved parallel H-bridge converter includes a first phase of H-bridge converter to a third phase of H-bridge converter. The first phase of H-bridge converter includes switching transistors Q1, Q2, Q7, and Q8, and a power inductor L1. The second phase of H-bridge converter includes switching transistors Q3, Q4, Q9, and Q10, and a power inductor L2. The third phase of H-bridge converter includes switching transistors Q5, Q6, Q11, and Q12, and a power inductor L3. The three phases of H-bridge converters are connected in parallel by using in1, in2, out1, and out2. In addition, the three-phase interleaved parallel H-bridge converter is connected to a first sampling resistor, and the first sampling resistor may be R1 or R2. In other words, the current sampling apparatus in this embodiment may include R1/R2. In addition, the current sampling apparatus in this embodiment may further include a sampling module 40 and a processing module 41.

Q1 to Q12 may be switching transistors including but not limited to a MOS transistor, an IGBT, a diode, or a bipolar transistor. L1, L2, and L3 may be independent inductors, or may be a three-phase integrated inductor.

The H-bridge converter works in a buck mode:
The processing module 41 controls Q7, Q9, and Q11 to be always turned on, controls Q8, Q10, and Q12 to be always turned off, and separately outputs, to Q1 to Q6, control signals whose periods are 1/f. In addition, control signals output to any two switching transistors in Q1, Q3, and Q5 have a phase difference of 120°, and control signals output to any two switching transistors in Q2, Q4, and Q6 have a phase difference of 120°, where f is a turn-on/turn-off frequency of a switching transistor, so that Q1 to Q6 are turned on or turned off based on the tum-on/tum-off frequency.

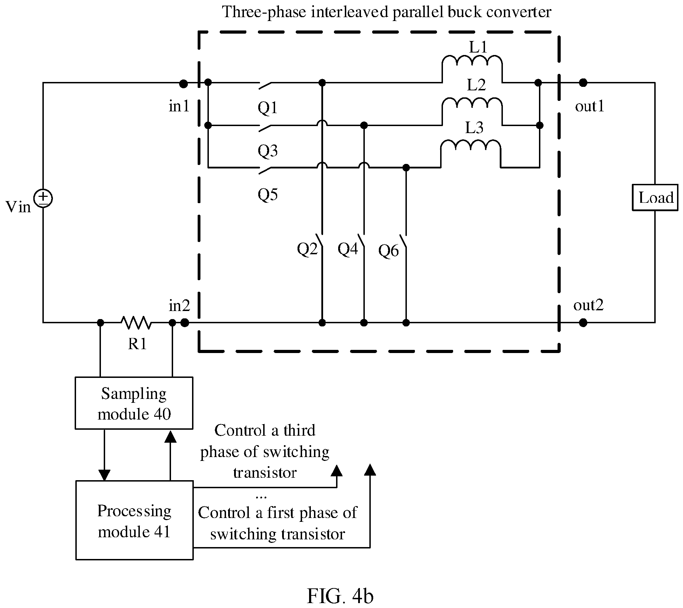

When the H-bridge converter works in the buck mode, the power supply in which the three-phase interleaved parallel H-bridge converter is used may be simplified as a power supply, shown in FIG. 4b, in which a three-phase interleaved parallel buck converter is used. As shown in FIG. 4b, the power supply includes Vin, a three-phase interleaved parallel buck converter, and a current sampling apparatus. The three-phase interleaved parallel buck converter includes a first phase of buck converter to a third phase of buck converter. The first phase of buck converter includes switching transistors Q1 and Q2, and a power inductor L1. The second phase of buck converter includes switching transistors Q3 and Q4, and a power inductor L2. The third phase of buck converter includes switching transistors Q5 and Q6, and a power inductor L3. The three phases of buck converters are connected in parallel by using in1, in2, out1, and out2. In addition, the three-phase interleaved parallel buck converter is connected to a first sampling resistor R1. The current sampling apparatus in this embodiment may include R1, and may further include a sampling module 40 and a processing module 41. The processing module 41 is configured to separately output control signals, to switching transistors (such as Q1 and Q3) at a same location in any two phases of buck converters in the three phases of buck converters, that have a phase difference of 120°.

In an implementation, the sampling module 40 is configured to collect a current of the first sampling resistor R1. The processing module 41 is configured to: obtain a current of R1 at a first moment and a current of R1 at a second moment, and determine, as an inductor current of the first phase of buck converter, a difference between the current of R1 at the first moment and the current of R1 at the second moment. Working circuits of the three phases of buck converters all pass through R1 at the first moment, the working circuit of the first phase of buck converter does not pass through R1 at the second moment, and the working circuits of both the second phase of buck converter and the third phase of buck converter pass through R1 at the second moment. For example, if the first moment is a midpoint moment in a time period in which a switching transistor in the first phase of buck converter is turned on, the second moment is a midpoint moment in a time period in which the same switching transistor in the first phase of buck converter is turned off. If the first moment is a midpoint moment in a time period in which a switching transistor in the first phase of buck converter is turned off, the second moment is a midpoint moment in a time period in which the same switching transistor in the first phase of buck converter is turned on.

Specifically, in a time period in which Q1 is turned on, L1 in the first phase of buck converter is in a charging state, and a current flowing out of a positive electrode of Vin arrives at L1 through Q1, and then arrives at a negative electrode of Vin from L1 through a load and R1, to form the working circuit of the first phase of buck converter. Vin stores energy for L1 by using the working circuit of the first phase of buck converter. In the time period in which Q1 is turned on, there is a time segment in which Q3 is in a turn-on state. The time segment includes a midpoint moment in the time period in which Q1 is turned on. L2 in the second phase of buck converter is in a charging state, and the current flowing out of the positive electrode of Vin arrives at L2 through Q3, and then arrives at the negative electrode of Vin from L2 through the load and R1, to form the working circuit of the second phase of buck converter. Vin stores energy for L2 by using the working circuit of the second phase of buck converter. In the time period in which Q1 is turned on, there is a time segment in which Q5 is in a turn-on state. The time segment includes the midpoint moment in the time period in which Q1 is turned on. L3 in the third phase of buck converter is in a charging state, and the current flowing out of the positive electrode of Vin arrives at L3 through Q5, and then arrives at the negative electrode of Vin from L3 through the load and R1, to form the working circuit of the third phase of buck converter. Vin stores energy for L3 by using the working circuit of the third phase of buck converter.

In a time period in which Q1 is turned off, Q2 is in a turn-on state, L1 in the first phase of buck converter is in a discharging state, and energy stored in L1 may be supplied to a load by using the working circuit that is of the first phase of buck converter and that is formed by L1 and Q2. In the time period in which Q1 is turned off, there is a time segment in which Q3 is in a turn-on state. The time segment includes a midpoint moment in the time period in which Q1 is turned off. L2 in the second phase of buck converter is in a charging state. In the time period in which Q1 is turned off, there is a time segment in which Q5 is in a turn-on state. The time segment includes the midpoint moment in the time period in which Q1 is turned off. L3 in the third phase of buck converter is in a charging state.

It may be understood that, in the time period in which Q1 is turned on, there is a time segment in which the working circuits of all the buck converters pass through R1. The time segment includes the midpoint moment in the time period in which Q1 is turned on. In the time period in which Q1 is turned off, there is a time segment in which the working circuit of the first phase of buck converter does not pass through R1 and the working circuits of both the second phase of buck converter and the third phase of buck converter pass through R1. The time segment includes the midpoint moment in the time period in which Q1 is turned off. The processing module 41 may obtain the current value of R1 at the first moment and the current value of R1 at the second moment, and determine, as the inductor current value of the first phase of buck converter, the difference between the current value of R1 at the first moment and the current value of R1 at the second moment. The first moment may be the midpoint moment in the time period in which Q1 is turned on, and the second moment may be the midpoint moment in the time period in which Q1 is turned off.

Similarly, it may be learned that, in a time period in which Q3 is turned on, there is a time segment in which the working circuits of all the buck converters pass through R1. The time segment includes a midpoint moment in the time period in which Q3 is turned on. In a time period in which Q3 is turned off, there is a time segment in which the working circuit of the second phase of buck converter does not pass through R1 and the working circuits of both the first phase of buck converter and the third phase of buck converter pass through R1. The time segment includes a midpoint moment in the time period in which Q3 is turned off. The processing module 41 may obtain the current value of R1 at the first moment and the current value of R1 at the second moment, and determine, as an inductor current value of the second phase of buck converter, the difference between the current value of R1 at the first moment and the current value of R1 at the second moment. The first moment may be the midpoint moment in the time period in which Q3 is turned on, and the second moment may be the midpoint moment in the time period in which Q3 is turned off.

Further, the current values of R1 at the midpoint moment in the time period in which Q1 is turned on and at the midpoint moment in the time period in which Q3 is turned on are equal and are a total current of the three phases of buck converters. Therefore, the processing module 41 may obtain the current value of R1 at the second moment, and determine, as the inductor current value of the second phase of buck converter, the difference between the current value of R1 at the first moment and the current value of R1 at the second moment. The first moment may be the midpoint moment in the time period in which Q1 is turned on, and the second moment may be the midpoint moment in the time period in which Q3 is turned off. Therefore, a quantity of sampling times is reduced, and working efficiency is improved.

Similarly, it may be learned that, in a time period in which Q5 is turned on, there is a time segment in which the working circuits of all the buck converters pass through R1. The time segment includes a midpoint moment in the time period in which Q5 is turned on. In a time period in which Q5 is turned off, there is a time segment in which the working circuit of the third phase of buck converter does not pass through R1 and the working circuits of both the first phase of buck converter and the second phase of buck converter pass through R1. The time segment includes a midpoint moment in the time period in which Q5 is turned off. The processing module 41 may obtain the current value of R1 at the first moment and the current value of R1 at the second moment, and determine, as an inductor current value of the third phase of buck converter, the difference between the current value of R1 at the first moment and the current value of R1 at the second moment. The first moment may be the midpoint moment in the time period in which Q5 is turned on, and the second moment may be the midpoint moment in the time period in which Q5 is turned off.

Further, the current values of R1 at the midpoint moment in the time period in which Q1 is turned on and at the midpoint moment in the time period in which Q5 is turned on are equal and are a total current of the three phases of buck converters. Therefore, the processing module 41 may obtain the current value of R1 at the second moment, and determine, as the inductor current value of the third phase of buck converter, the difference between the current value of R1 at the first moment and the current value of R1 at the second moment. The first moment may be the midpoint moment in the time period in which Q1 is turned on, and the second moment may be the midpoint moment in the time period in which Q5 is turned off. Therefore, a quantity of sampling times is reduced, and working efficiency is improved.

Based on the foregoing power supply, this application further provides a current sampling method, including:
When determining, at a first moment, that working circuits of all converters in a multiphase interleaved parallel converter pass through a first sampling resistor, the processing module 41 obtains a first current of the first sampling resistor; obtains a second current of the first sampling resistor at a second moment at which a working circuit of a first phase of converter does not pass through the first sampling resistor and a working circuit of another converter in the multiphase interleaved parallel converter passes through the first sampling resistor; and determines, as an inductor current of the first phase of converter, a difference between the first current of the first sampling resistor and the second current of the first sampling resistor. The first sampling resistor is connected to an input end of the multiphase interleaved parallel converter.

The H-bridge converter works in a boost mode:
The processing module 41 controls Q1, Q3, and Q5 to be always turned on, controls Q2, Q4, and Q6 to be always turned off, and separately outputs, to Q7 to Q12, control signals whose periods are 1/f. In addition, control signals output to any two switching transistors in Q7, Q9, and Q11 have a phase difference of 120°, and control signals output to any two switching transistors in Q8, Q10, and Q12 have a phase difference of 120°, where f is a turn-on/turn-off frequency of a switching transistor, so that Q7 to Q12 are turned on or turned off based on the turn-on/turn-off frequency.

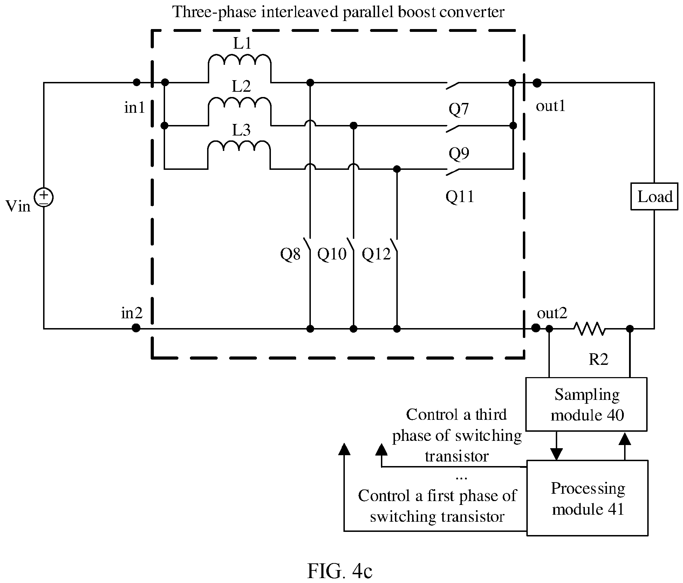

When the H-bridge converter works in the boost mode, the power supply in which the three-phase interleaved parallel H-bridge converter is used may be simplified as a power supply, shown in FIG. 4c, in which a three-phase interleaved parallel boost converter is used. As shown in FIG. 4c, the power supply includes Vin, a three-phase interleaved parallel boost converter, and a current sampling apparatus. The three-phase interleaved parallel boost converter includes a first phase of boost converter to a third phase of boost converter. The first phase of boost converter includes switching transistors Q7 and Q8, and a power inductor L1. The second phase of boost converter includes switching transistors Q9 and Q10, and a power inductor L2. The third phase of boost converter includes switching transistors Q11 and Q12, and a power inductor L3. The three phases of boost converters are connected in parallel by using in1, in2, out1, and out2. In addition, the three-phase interleaved parallel boost converter is connected to a first sampling resistor R2. The current sampling apparatus in this embodiment may include R2, and may further include a sampling module 40 and a processing module 41. The processing module 41 is configured to separately output control signals, to switching transistors (such as Q8 and Q10) at a same location in any two phases of boost converters in the three phases of boost converters, that have a phase difference of 120°.

In an implementation, the sampling module 40 is configured to collect a current of the first sampling resistor R2. The processing module 41 is configured to: obtain a current of R2 at a first moment and a current of R2 at a second moment, and determine, as an inductor current of the first phase of boost converter, a difference between the current of R2 at the first moment and the current of R2 at the second moment. Working circuits of the three phases of boost converters all pass through R2 at the first moment, the working circuit of the first phase of boost converter does not pass through R2 at the second moment, and the working circuits of both the second phase of boost converter and the third phase of boost converter pass through R2 at the second moment. For example, if the first moment is a midpoint moment in a time period in which a switching transistor in the first phase of boost converter is turned on, the second moment is a midpoint moment in a time period in which the same switching transistor in the first phase of boost converter is turned off. If the first moment is a midpoint moment in a time period in which a switching transistor in the first phase of boost converter is turned off, the second moment is a midpoint moment in a time period in which the same switching transistor in the first phase of boost converter is turned on.

Specifically, in a time period in which Q7 is turned on, L1 in the first phase of boost converter is in a discharging state, and a current flowing out of a positive electrode of Vin arrives at Q7 through L1, and then arrives at a negative electrode of Vin from Q7 through R2, to form the working circuit of the first phase of boost converter. Vin supplies energy to a load by using the working circuit of the first phase of boost converter. In the time period in which Q7 is turned on, there is a time segment in which Q9 is in a turn-on state. The time segment includes a midpoint moment in the time period in which Q7 is turned on. L2 in the second phase of boost converter is in a discharging state, and the current flowing out of the positive electrode of Vin arrives at Q9 through L2, and then arrives at the negative electrode of Vin from Q9 through R2, to form the working circuit of the second phase of boost converter. Vin supplies energy to the load by using the working circuit of the second phase of boost converter. In the time period in which Q7 is turned on, there is a time segment in which Q11 is in a turn-on state. The time segment includes a midpoint moment in the time period in which Q7 is turned on. L3 in the third phase of boost converter is in a discharging state, and the current flowing out of the positive electrode of Vin arrives at Q11 through L3, and then arrives at the negative electrode of Vin from Q11 through R2, to form the working circuit of the third phase of boost converter. Vin supplies energy to the load by using the working circuit of the third phase of boost converter.

In a time period in which Q7 is turned off, Q8 is in a turn-on state, L1 in the first phase of boost converter is in a charging state, and a current flowing out of a positive electrode of Vin arrives at a negative electrode of Vin from L1 through Q8, to form the working circuit of the first phase of boost converter. Vin stores energy for L1 by using the working circuit of the first phase of boost converter. In the time period in which Q7 is turned off, there is a time segment in which Q9 is in a turn-on state. The time segment includes a midpoint moment in the time period in which Q7 is turned off. L2 in the second phase of boost converter is in a discharging state. In the time period in which Q7 is turned off, there is a time segment in which Q11 is in a turn-on state. The time segment includes the midpoint moment in the time period in which Q7 is turned off. L3 in the third phase of boost converter is in a discharging state.

It may be understood that, in the time period in which Q7 is turned on, there is a time segment in which the working circuits of all the boost converters pass through R2. The time segment includes the midpoint moment in the time period in which Q7 is turned on. In the time period in which Q7 is turned off, there is a time segment in which the working circuit of the first phase of boost converter does not pass through R2 and the working circuits of both the second phase of boost converter and the third phase of boost converter pass through R2. The time segment includes the midpoint moment in the time period in which Q7 is turned off. The processing module 41 may obtain the current value of R2 at the first moment and the current value of R2 at the second moment, and determine, as the inductor current value of the first phase of boost converter, the difference between the current value of R2 at the first moment and the current value of R2 at the second moment. The first moment may be the midpoint moment in the time period in which Q7 is turned on, and the second moment may be the midpoint moment in the time period in which Q7 is turned off.

Similarly, it may be learned that, in a time period in which Q9 is turned on, there is a time segment in which the working circuits of all the boost converters pass through R2. The time segment includes a midpoint moment in the time period in which Q9 is turned on. In a time period in which Q9 is turned off, there is a time segment in which the working circuit of the second phase of boost converter does not pass through R2 and the working circuits of both the first phase of boost converter and the third phase of boost converter pass through R2. The time segment includes a midpoint moment in the time period in which Q9 is turned off. The processing module 41 may obtain the current value of R2 at the first moment and the current value of R2 at the second moment, and determine, as an inductor current value of the second phase of boost converter, the difference between the current value of R2 at the first moment and the current value of R2 at the second moment. The first moment may be the midpoint moment in the time period in which Q9 is turned on, and the second moment may be the midpoint moment in the time period in which Q9 is turned off.

Further, the current values of R2 at the midpoint moment in the time period in which Q7 is turned on and at the midpoint moment in the time period in which Q9 is turned on are equal and are a total current of the three phases of boost converters. Therefore, the processing module 41 may obtain the current value of R2 at the second moment, and determine, as the inductor current value of the second phase of boost converter, the difference between the current value of R2 at the first moment and the current value of R2 at the second moment. The first moment may be the midpoint moment in the time period in which Q7 is turned on, and the second moment may be the midpoint moment in the time period in which Q9 is turned off. Therefore, a quantity of sampling times is reduced, and working efficiency is improved.

Similarly, it may be learned that, in a time period in which Q11 is turned on, there is a time segment in which the working circuits of all the boost converters pass through R2. The time segment includes a midpoint moment in the time period in which Q11 is turned on. In a time period in which Q11 is turned off, there is a time segment in which the working circuit of the third phase of boost converter does not pass through R2 and the working circuits of both the first phase of boost converter and the second phase of boost converter pass through R2. The time segment includes a midpoint moment in the time period in which Q11 is turned off. The processing module 41 may obtain the current value of R2 at the first moment and the current value of R2 at the second moment, and determine, as an inductor current value of the third phase of boost converter, the difference between the current value of R2 at the first moment and the current value of R2 at the second moment. The first moment may be the midpoint moment in the time period in which Q11 is turned on, and the second moment may be the midpoint moment in the time period in which Q11 is turned off.

Further, the current values of R2 at the midpoint moment in the time period in which Q7 is turned on and at the midpoint moment in the time period in which Q11 is turned on are equal and are a total current of the three phases of boost converters. Therefore, the processing module 41 may obtain the current value of R2 at the second moment, and determine, as the inductor current value of the third phase of boost converter, the difference between the current value of R2 at the first moment and the current value of R2 at the second moment. The first moment may be the midpoint moment in the time period in which Q7 is turned on, and the second moment may be the midpoint moment in the time period in which Q11 is turned off. Therefore, a quantity of sampling times is reduced, and working efficiency is improved.

Based on the foregoing power supply, this application further provides a current sampling method, including:
When determining, at a first moment, that working circuits of all converters in a multiphase interleaved parallel converter pass through a first sampling resistor, the processing module 41 obtains a first current of the first sampling resistor; obtains a second current of the first sampling resistor at a second moment at which a working circuit of a first phase of converter does not pass through the first sampling resistor and a working circuit of another converter in the multiphase interleaved parallel converter passes through the first sampling resistor; and determines, as an inductor current of the first phase of converter, a difference between the first current of the first sampling resistor and the second current of the first sampling resistor. The first sampling resistor is connected to an output end of the multiphase interleaved parallel converter.

Still refer to FIG. 4a. The H-bridge converter works in a buck-boost mode:
The processing module 41 separately outputs, to the switching transistors Q1 to Q12, control signals whose periods are 1/f. In addition, control signals output to two switching transistors (such as Q1 and Q8, and Q2 and Q7) that are in a same converter and that have a diagonal location relationship have a phase difference of 0°, and control signals output to two switching transistors (such as Q1 and Q3, Q1 and Q5, and Q3 and Q5) at a same location in any two phases of converters in the three phases of H-bridge converters have a phase difference of 120°, where f is a tum-on/tum-off frequency of a switching transistor.

In an implementation, the sampling module 40 is configured to collect a current of the first sampling resistor R1. The processing module 41 is configured to: obtain a current of R1 at a first moment and a current of R1 at a second moment, and determine, as an inductor current of the first phase of H-bridge converter, a difference between the current of R1 at the first moment and the current of R1 at the second moment. Working circuits of the three phases of H-bridge converters all pass through R1 at the first moment, the working circuit of the first phase of H-bridge converter does not pass through R1 at the second moment, and the working circuits of both the second phase of H-bridge converter and the third phase of H-bridge converter pass through R1 at the second moment. For example, if the first moment is a midpoint moment in a time period in which a switching transistor in the first phase of H-bridge converter is turned on, the second moment is a midpoint moment in a time period in which the same switching transistor in the first phase of H-bridge converter is turned off. If the first moment is a midpoint moment in a time period in which a switching transistor in the first phase of H-bridge converter is turned off, the second moment is a midpoint moment in a time period in which the same switching transistor in the first phase of H-bridge converter is turned on.

Specifically, in a time period in which Q1 and Q8 are turned on, L1 in the first phase of H-bridge converter is in a charging state, and a current flowing out of a positive electrode of Vin arrives at L1 through Q1, and then arrives at a negative electrode of Vin from L1 through Q8 and R1, to form the working circuit of the first phase of H-bridge converter. Vin stores energy for L1 by using the working circuit of the first phase of H-bridge converter. In the time period in which Q1 and Q8 are turned on, there is a time segment in which Q3 and Q10 are in a turn-on state. The time segment includes a midpoint moment in the time period in which Q1 and Q8 are turned on. L2 in the second phase of H-bridge converter is in a charging state, and the current flowing out of the positive electrode of Vin arrives at L2 through Q3, and then arrives at the negative electrode of Vin from L2 through Q10 and R1, to form the working circuit of the second phase of H-bridge converter. Vin stores energy for L2 by using the working circuit of the second phase of H-bridge converter. In the time period in which Q1 and Q8 are turned on, there is a time segment in which Q5 and Q12 are in a turn-on state. The time segment includes the midpoint moment in the time period in which Q1 and Q8 are turned on. L3 in the third phase of H-bridge converter is in a charging state, and the current flowing out of the positive electrode of Vin arrives at L3 through Q5, and then arrives at the negative electrode of Vin from L3 through Q12 and R1, to form the working circuit of the third phase of H-bridge converter. Vin stores energy for L3 by using the working circuit of the third phase of H-bridge converter.

In a time period in which Q1 and Q8 are turned off, Q2 and Q7 are in a turn-on state, L1 in the first phase of H-bridge converter is in a discharging state, and energy stored in L1 may be supplied to a load by using the working circuit that is of the first phase of H-bridge converter and that is formed by L1, Q7, the load, and Q2. In the time period in which Q1 and Q8 are turned off, there is a time segment in which Q3 and Q10 are in a turn-on state. The time segment includes a midpoint moment in the time period in which Q1 and Q8 are turned off. L2 in the second phase of H-bridge converter is in a charging state. In the time period in which Q1 and Q8 are turned off, there is a time segment in which Q5 and Q12 are in a turn-on state. The time segment includes the midpoint moment in the time period in which Q1 and Q8 are turned off. L3 in the third phase of H-bridge converter is in a charging state.

It may be understood that, in the time period in which Q1 and Q8 are turned on, there is a time segment in which the working circuits of all the H-bridge converters pass through R1. The time segment includes the midpoint moment in the time period in which Q1 and Q8 are turned on. In the time period in which Q1 and Q8 are turned off, there is a time segment in which the working circuit of the first phase of H-bridge converter does not pass through R1 and the working circuits of both the second phase of H-bridge converter and the third phase of H-bridge converter pass through R1. The time segment includes the midpoint moment in the time period in which Q1 and Q8 are turned off. The processing module 41 may obtain the current value of R1 at the first moment and the current value of R1 at the second moment, and determine, as the inductor current value of the first phase of H-bridge converter, the difference between the current value of R1 at the first moment and the current value of R1 at the second moment. The first moment may be the midpoint moment in the time period in which Q1 and Q8 are turned on, and the second moment may be the midpoint moment in the time period in which Q1 and Q8 are turned off.

Similarly, it may be understood that, in a time period in which Q3 and Q10 are turned on, there is a time segment in which the working circuits of all the H-bridge converters pass through R1. The time segment includes a midpoint moment in the time period in which Q3 and Q10 are turned on. In a time period in which Q3 and Q10 are turned off, there is a time segment in which the working circuit of the second phase of H-bridge converter does not pass through R1 and the working circuits of both the first phase of H-bridge converter and the third phase of H-bridge converter pass through R1. The time segment includes a midpoint moment in the time period in which Q3 and Q10 are turned off. The processing module 41 may obtain the current value of R1 at the first moment and the current value of R1 at the second moment, and determine, as an inductor current value of the second phase of H-bridge converter, the difference between the current value of R1 at the first moment and the current value of R1 at the second moment. The first moment may be the midpoint moment in the time period in which Q3 and Q10 are turned on, and the second moment may be the midpoint moment in the time period in which Q3 and Q10 are turned off.

Further, the current values of R1 at the midpoint moment in the time period in which Q1 and Q8 are turned on and at the midpoint moment in the time period in which Q3 and Q10 are turned on are equal and are a total current of the three phases of H-bridge converters. Therefore, the processing module 41 may obtain the current value of R1 at the second moment, and determine, as the inductor current value of the second phase of H-bridge converter, the difference between the current value of R1 at the first moment and the current value of R1 at the second moment. The first moment may be the midpoint moment in the time period in which Q1 and Q8 are turned on, and the second moment may be the midpoint moment in the time period in which Q3 and Q10 are turned off. Therefore, a quantity of sampling times is reduced, and working efficiency is improved.

Similarly, it may be understood that, in a time period in which Q5 and Q12 are turned on, there is a time segment in which the working circuits of all the H-bridge converters pass through R1. The time segment includes a midpoint moment in the time period in which Q5 and Q12 are turned on. In a time period in which Q5 and Q12 are turned off, there is a time segment in which the working circuit of the third phase of H-bridge converter does not pass through R1 and the working circuits of both the first phase of H-bridge converter and the second phase of H-bridge converter pass through R1. The time segment includes a midpoint moment in the time period in which Q5 and Q12 are turned off. The processing module 41 may obtain the current value of R1 at the first moment and the current value of R1 at the second moment, and determine, as an inductor current value of the third phase of H-bridge converter, the difference between the current value of R1 at the first moment and the current value of R1 at the second moment. The first moment may be the midpoint moment in the time period in which Q5 and Q12 are turned on, and the second moment may be the midpoint moment in the time period in which Q5 and Q12 are turned off.

Further, the current values of R1 at the midpoint moment in the time period in which Q1 and Q8 are turned on and at the midpoint moment in the time period in which Q5 and Q12 are turned on are equal and are a total current of the three phases of H-bridge converters. Therefore, the processing module 41 may obtain the current value of R1 at the second moment, and determine, as the inductor current value of the third phase of H-bridge converter, the difference between the current value of R1 at the first moment and the current value of R1 at the second moment. The first moment may be the midpoint moment in the time period in which Q1 and Q8 are turned on, and the second moment may be the midpoint moment in the time period in which Q5 and Q12 are turned off. Therefore, a quantity of sampling times is reduced, and working efficiency is improved.

Based on the foregoing power supply, this application further provides a current sampling method, including:
When determining, at a first moment, that working circuits of all converters in a multiphase interleaved parallel converter pass through a first sampling resistor, the processing module 41 obtains a first current of the first sampling resistor; obtains a second current of the first sampling resistor at a second moment at which a working circuit of a first phase of converter does not pass through the first sampling resistor and a working circuit of another converter in the multiphase interleaved parallel converter passes through the first sampling resistor; and determines, as an inductor current of the first phase of converter, a difference between the first current of the first sampling resistor and the second current of the first sampling resistor. The first sampling resistor is connected to an input end of the multiphase interleaved parallel converter.

In another implementation, the sampling module 40 is configured to collect a current of the first sampling resistor R2. The processing module 41 is configured to: obtain a current of R2 at a first moment and a current of R2 at a second moment, and determine, as an inductor current of the first phase of H-bridge converter, a difference between the current of R2 at the first moment and the current of R2 at the second moment. Working circuits of the three phases of H-bridge converters all pass through R2 at the first moment, the working circuit of the first phase of H-bridge converter does not pass through R2 at the second moment, and the working circuits of both the second phase of H-bridge converter and the third phase of H-bridge converter pass through R2 at the second moment. For example, if the first moment is a midpoint moment in a time period in which a switching transistor in the first phase of H-bridge converter is turned on, the second moment is a midpoint moment in a time period in which the same switching transistor in the first phase of H-bridge converter is turned off. If the first moment is a midpoint moment in a time period in which a switching transistor in the first phase of H-bridge converter is turned off, the second moment is a midpoint moment in a time period in which the same switching transistor in the first phase of H-bridge converter is turned on.

Specifically, in a time period in which Q2 and Q7 are turned on, L1 in the first phase of H-bridge converter is in a discharging state, and energy stored in L1 may be supplied to a load by using the working circuit that is of the first phase of H-bridge converter and that is formed by L1, Q7, R2, and Q2. In the time period in which Q2 and Q7 are turned on, there is a time segment in which Q4 and Q9 are in a turn-on state. The time segment includes a midpoint moment in the time period in which Q2 and Q7 are turned on. L2 in the second phase of H-bridge converter is in a discharging state, and energy stored in L2 may be supplied to the load by using the working circuit that is of the second phase of H-bridge converter and that is formed by L2, Q9, R2, and Q4. In the time period in which Q2 and Q7 are turned on, there is a time segment in which Q6 and Q11 are in a turn-on state. The time segment includes the midpoint moment in the time period in which Q2 and Q7 are turned on. L3 in the third phase of H-bridge converter is in a discharging state, and energy stored in L3 may be supplied to the load by using the working circuit that is of the third phase of H-bridge converter and that is formed by L3, Q11, R2, and Q6.

In a time period in which Q2 and Q7 are turned off, Q1 and Q8 are in a turn-on state, L1 in the first phase of H-bridge converter is in a charging state, and a current flowing out of a positive electrode of Vin arrives at L1 through Q1, and then arrives at a negative electrode of Vin from L1 through Q8, to form the working circuit of the first phase of H-bridge converter. Vin stores energy for L1 by using the working circuit of the first phase of H-bridge converter. In the time period in which Q2 and Q7 are turned off, there is a time segment in which Q4 and Q9 are in a turn-on state. The time segment includes a midpoint moment in the time period in which Q2 and Q7 are turned off. L2 in the second phase of H-bridge converter is in a discharging state. In the time period in which Q2 and Q7 are turned off, there is a time segment in which Q6 and Q11 are in a turn-on state. The time segment includes the midpoint moment in the time period in which Q2 and Q7 are turned off. L3 in the third phase of H-bridge converter is in a discharging state.

It may be understood that, in the time period in which Q2 and Q7 are turned on, there is a time segment in which the working circuits of all the H-bridge converters pass through R2. The time segment includes the midpoint moment in the time period in which Q2 and Q7 are turned on. In the time period in which Q2 and Q7 are turned off, there is a time segment in which the working circuit of the first phase of H-bridge converter does not pass through R2 and the working circuits of both the second phase of H-bridge converter and the third phase of H-bridge converter pass through R2. The time segment includes the midpoint moment in the time period in which Q2 and Q7 are turned off. The processing module 41 may obtain the current value of R2 at the first moment and the current value of R2 at the second moment, and determine, as the inductor current value of the first phase of H-bridge converter, the difference between the current value of R2 at the first moment and the current value of R2 at the second moment. The first moment may be the midpoint moment in the time period in which Q2 and Q7 are turned on, and the second moment may be the midpoint moment in the time period in which Q2 and Q7 are turned off.

Similarly, it may be understood that, in a time period in which Q4 and Q9 are turned on, there is a time segment in which the working circuits of all the H-bridge converters pass through R2. The time segment includes a midpoint moment in the time period in which Q4 and Q9 are turned on. In a time period in which Q4 and Q9 are turned off, there is a time segment in which the working circuit of the second phase of H-bridge converter does not pass through R2 and the working circuits of both the first phase of H-bridge converter and the third phase of H-bridge converter pass through R2. The time segment includes a midpoint moment in the time period in which Q4 and Q9 are turned off. The processing module 41 may obtain the current value of R2 at the first moment and the current value of R2 at the second moment, and determine, as an inductor current value of the second phase of H-bridge converter, the difference between the current value of R2 at the first moment and the current value of R2 at the second moment. The first moment may be the midpoint moment in the time period in which Q4 and Q9 are turned on, and the second moment may be the midpoint moment in the time period in which Q4 and Q9 are turned off.

Further, the current values of R2 at the midpoint moment in the time period in which Q2 and Q7 are turned on and at the midpoint moment in the time period in which Q4 and Q9 are turned on are equal and are a total current of the three phases of H-bridge converters. Therefore, the processing module 41 may obtain the current value of R2 at the second moment, and determine, as the inductor current value of the second phase of H-bridge converter, the difference between the current value of R2 at the first moment and the current value of R2 at the second moment. The first moment may be the midpoint moment in the time period in which Q2 and Q7 are turned on, and the second moment may be the midpoint moment in the time period in which Q4 and Q9 are turned off. Therefore, a quantity of sampling times is reduced, and working efficiency is improved.

Similarly, it may be understood that, in a time period in which Q6 and Q11 are turned on, there is a time segment in which the working circuits of all the H-bridge converters pass through R2. The time segment includes a midpoint moment in the time period in which Q6 and Q11 are turned on. In a time period in which Q6 and Q11 are turned off, there is a time segment in which the working circuit of the third phase of H-bridge converter does not pass through R2 and the working circuits of both the first phase of H-bridge converter and the second phase of H-bridge converter pass through R2. The time segment includes a midpoint moment in the time period in which Q6 and Q11 are turned off. The processing module 41 may obtain the current value of R2 at the first moment and the current value of R2 at the second moment, and determine, as an inductor current value of the third phase of H-bridge converter, the difference between the current value of R2 at the first moment and the current value of R2 at the second moment. The first moment may be the midpoint moment in the time period in which Q6 and Q11 are turned on, and the second moment may be the midpoint moment in the time period in which Q6 and Q11 are turned off.

Further, the current values of R2 at the midpoint moment in the time period in which Q2 and Q7 are turned on and at the midpoint moment in the time period in which Q6 and Q11 are turned on are equal and are a total current of the three phases of H-bridge converters. Therefore, the processing module 41 may obtain the current value of R2 at the second moment, and determine, as the inductor current value of the third phase of H-bridge converter, the difference between the current value of R2 at the first moment and the current value of R2 at the second moment. The first moment may be the midpoint moment in the time period in which Q2 and Q7 are turned on, and the second moment may be the midpoint moment in the time period in which Q6 and Q11 are turned off. Therefore, a quantity of sampling times is reduced, and working efficiency is improved.

Based on the foregoing power supply, this application further provides a current sampling method, including:
When determining, at a first moment, that working circuits of all converters in a multiphase interleaved parallel converter pass through a first sampling resistor, the processing module 41 obtains a first current of the first sampling resistor; obtains a second current of the first sampling resistor at a second moment at which a working circuit of a first phase of converter does not pass through the first sampling resistor and a working circuit of another converter in the multiphase interleaved parallel converter passes through the first sampling resistor; and determines, as an inductor current of the first phase of converter, a difference between the first current of the first sampling resistor and the second current of the first sampling resistor. The first sampling resistor is connected to an output end of the multiphase interleaved parallel converter.

In this embodiment of this application, when the working circuit of the first phase of H-bridge converter passes through the first sampling resistor R1 or R2 at the first moment, and the working circuits of both the second phase of H-bridge converter and the third phase of H-bridge converter pass through the first sampling resistor at the first moment, the processing module 41 determines, as the inductor current value of the first phase of H-bridge converter, the difference between the current value of the first sampling resistor at the first moment and the current value of the first sampling resistor at the second moment.

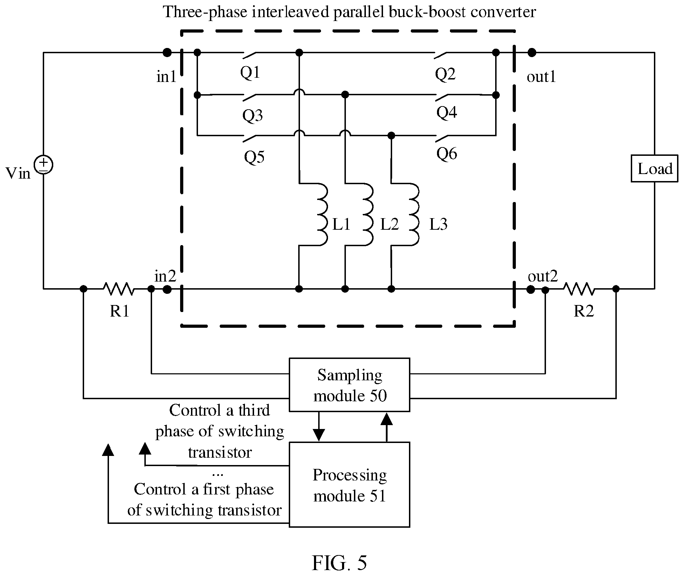

For example, FIG. 5 is a schematic diagram of a structure of a power supply in which a three-phase interleaved parallel buck-boost converter is used according to this application. As shown in FIG. 5, the power supply includes Vin, a three-phase interleaved parallel buck-boost converter, and a current sampling apparatus. The three-phase interleaved parallel buck-boost converter includes a first phase of buck-boost converter to a third phase of buck-boost converter. The first phase of buck-boost converter includes switching transistors Q1 and Q2, and a power inductor L1. The second phase of buck-boost converter includes switching transistors Q3 and Q4, and a power inductor L2. The third phase of buck-boost converter includes switching transistors Q5 and Q6, and a power inductor L3. The three phases of buck-boost converters are connected in parallel by using in1, in2, out1, and out2. In addition, the three-phase parallel buck-boost converter is connected to a first sampling resistor, and the first sampling resistor may be R1 or R2. In other words, the current sampling apparatus in this embodiment may include R1/R2. In addition, the current sampling apparatus in this embodiment may further include a sampling module 50 and a processing module 51. The processing module 51 is configured to separately output control signals, to switching transistors (such as Q1 and Q3) at a same location in any two phases of buck-boost converters in the three phases of buck-boost converters, that have a phase difference of 120°.

Q1 to Q6 may be switching transistors including but not limited to a MOS transistor, an IGBT, a diode, or a bipolar transistor. L1, L2, and L3 may be independent inductors, or may be a three-phase integrated inductor.

In an implementation, the sampling module 50 is configured to collect a current of the first sampling resistor R1. The processing module 51 is configured to: obtain a current of R1 at a first moment and a current of R1 at a second moment, and determine, as an inductor current of the first phase of buck-boost converter, a difference between the current of R1 at the first moment and the current of R1 at the second moment. Working circuits of the three phases of buck-boost converters all pass through R1 at the first moment, the working circuit of the first phase of buck-boost converter does not pass through R1 at the second moment, and the working circuits of both the second phase of buck-boost converter and the third phase of buck-boost converter pass through R1 at the second moment. For example, if the first moment is a midpoint moment in a time period in which a switching transistor in the first phase of buck-boost converter is turned on, the second moment is a midpoint moment in a time period in which the same switching transistor in the first phase of buck-boost converter is turned off. If the first moment is a midpoint moment in a time period in which a switching transistor in the first phase of buck-boost converter is turned off, the second moment is a midpoint moment in a time period in which the same switching transistor in the first phase of buck-boost converter is turned on.

Specifically, in a time period in which Q1 is turned on, L1 in the first phase of buck-boost converter is in a charging state, and a current flowing out of a positive electrode of Vin arrives at L1 through Q1, and then arrives at a negative electrode of Vin from L1 through R1, to form the working circuit of the first phase of buck-boost converter. Vin stores energy for L1 by using the working circuit of the first phase of buck-boost converter. In the time period in which Q1 is turned on, there is a time segment in which Q3 is in a turn-on state. The time segment includes a midpoint moment in the time period in which Q1 is turned on. L2 in the second phase of buck-boost converter is in a charging state, and the current flowing out of the positive electrode of Vin arrives at L2 through Q3, and then arrives at the negative electrode of Vin from L2 through R1, to form the working circuit of the second phase of buck-boost converter. Vin stores energy for L2 by using the working circuit of the second phase of buck-boost converter. In the time period in which Q1 is turned on, there is a time segment in which Q5 is in a turn-on state. The time segment includes a midpoint moment in the time period in which Q1 is turned on. L3 in the third phase of buck-boost converter is in a charging state, and the current flowing out of the positive electrode of Vin arrives at L3 through Q5, and then arrives at the negative electrode of Vin from L3 through R1, to form the working circuit of the third phase of buck-boost converter. Vin stores energy for L3 by using the working circuit of the third phase of buck-boost converter.

In a time period in which Q1 is turned off, Q2 is in a turn-on state, L1 in the first phase of buck-boost converter is in a discharging state, and energy stored in L1 may be supplied to a load by using the working circuit that is of the first phase of H-bridge converter and that is formed by L1 and Q2. In the time period in which Q1 is turned off, there is a time segment in which Q3 is in a turn-on state. The time segment includes a midpoint moment in the time period in which Q1 is turned off. L2 in the second phase of buck-boost converter is in a charging state. When Q1 is in a turn-off state, there is a time segment in which Q5 is in a turn-on state. The time segment includes the midpoint moment in the time period in which Q1 is turned off. L3 in the third phase of buck-boost converter is in a charging state.

It may be understood that, in the time period in which Q1 is turned on, there is a time segment in which the working circuits of all the buck-boost converters pass through R1. The time segment includes the midpoint moment in the time period in which Q1 is turned on. In the time period in which Q1 is turned off, there is a time segment in which the working circuit of the first phase of buck-boost converter does not pass through R1 and the working circuits of both the second phase of buck-boost converter and the third phase of buck-boost converter pass through R1. The time segment includes the midpoint moment in the time period in which Q1 is turned off. The processing module 51 may obtain the current value of R1 at the first moment and the current value of R1 at the second moment, and determine, as the inductor current value of the first phase of buck-boost converter, the difference between the current value of R1 at the first moment and the current value of R1 at the second moment. The first moment may be the midpoint moment in the time period in which Q1 is turned on, and the second moment may be the midpoint moment in the time period in which Q1 is turned off.

Similarly, it may be learned that, in a time period in which Q3 is turned on, there is a time segment in which the working circuits of all the buck-boost converters pass through R1. The time segment includes a midpoint moment in the time period in which Q3 is turned on. In a time period in which Q3 is turned off, there is a time segment in which the working circuit of the second phase of buck-boost converter does not pass through R1 and the working circuits of both the first phase of buck-boost converter and the third phase of buck-boost converter pass through R1. The time segment includes a midpoint moment in the time period in which Q3 is turned off. The processing module 51 may obtain the current value of R1 at the first moment and the current value of R1 at the second moment, and determine, as an inductor current value of the second phase of buck-boost converter, the difference between the current value of R1 at the first moment and the current value of R1 at the second moment. The first moment may be the midpoint moment in the time period in which Q3 is turned on, and the second moment may be the midpoint moment in the time period in which Q3 is turned off.

In a time period in which Q5 is turned on, there is a time segment in which the working circuits of all the buck-boost converters pass through R1. The time segment includes a midpoint moment in the time period in which Q5 is turned on. In a time period in which Q5 is turned off, there is a time segment in which the working circuit of the third phase of buck-boost converter does not pass through R1 and the working circuits of both the first phase of buck-boost converter and the second phase of buck-boost converter pass through R1. The time segment includes a midpoint moment in the time period in which Q5 is turned off. The processing module 51 may obtain the current value of R1 at the first moment and the current value of R1 at the second moment, and determine, as an inductor current value of the third phase of buck-boost converter, the difference between the current value of R1 at the first moment and the current value of R1 at the second moment. The first moment may be the midpoint moment in the time period in which Q5 is turned on, and the second moment may be the midpoint moment in the time period in which Q5 is turned off.

Based on the foregoing power supply, this application further provides a current sampling method, including:
When determining, at a first moment, that working circuits of all converters in a multiphase interleaved parallel converter pass through a first sampling resistor, the processing module 51 obtains a first current of the first sampling resistor; obtains a second current of the first sampling resistor at a second moment at which a working circuit of a first phase of converter does not pass through the first sampling resistor and a working circuit of another converter in the multiphase interleaved parallel converter passes through the first sampling resistor; and determines, as an inductor current of the first phase of converter, a difference between the first current of the first sampling resistor and the second current of the first sampling resistor. The first sampling resistor is connected to an input end of the multiphase interleaved parallel converter.

In another implementation, the sampling module 50 is configured to collect a current of the first sampling resistor R2. The processing module 51 is configured to: obtain a current of R2 at a first moment and a current of R2 at a second moment, and determine, as an inductor current of the first phase of buck-boost converter, a difference between the current of R2 at the first moment and the current of R2 at the second moment. Working circuits of the three phases of buck-boost converters all pass through R2 at the first moment, the working circuit of the first phase of buck-boost converter does not pass through R2 at the second moment, and the working circuits of both the second phase of buck-boost converter and the third phase of buck-boost converter pass through R2 at the second moment. For example, if the first moment is a midpoint moment in a time period in which a switching transistor in the first phase of buck-boost converter is turned on, the second moment is a midpoint moment in a time period in which the same switching transistor in the first phase of buck-boost converter is turned off. If the first moment is a midpoint moment in a time period in which a switching transistor in the first phase of buck-boost converter is turned off, the second moment is a midpoint moment in a time period in which the same switching transistor in the first phase of buck-boost converter is turned on.

Specifically, in a time period in which Q2 is turned on, L1 in the first phase of buck-boost converter is in a discharging state, and energy stored in L1 may be supplied to a load by using the working circuit that is of the first phase of buck-boost converter and that is formed by L1, Q2, and R2. In the time period in which Q2 is turned on, there is a time segment in which Q4 is in a turn-on state. The time segment includes a midpoint moment in the time period in which Q2 is turned on. L2 in the second phase of buck-boost converter is in a discharging state, and energy stored in L2 may be supplied to the load by using the working circuit that is of the second phase of buck-boost converter and that is formed by L2, Q4, and R2. In the time period in which Q2 is turned on, there is a time segment in which Q6 is in a turn-on state. The time segment includes the midpoint moment in the time period in which Q2 is turned on. L3 in the third phase of buck-boost converter is in a discharging state, and energy stored in L3 may be supplied to the load by using the working circuit that is of the third phase of buck-boost converter and that is formed by L3, Q6, and R2.

In a time period in which Q2 is turned off, Q1 is in a turn-on state, L1 in the first phase of buck-boost converter is in a charging state, and a current flowing out of a positive electrode of Vin arrives at L1 through Q1, and then arrives at a negative electrode of Vin from L1, to form the working circuit of the first phase of buck-boost converter. Vin stores energy for L1 by using the working circuit of the first phase of buck-boost converter. In the time period in which Q2 is turned off, there is a time segment in which Q4 is in a turn-on state. The time segment includes a midpoint moment in the time period in which Q2 is turned off. L2 in the second phase of buck-boost converter is in a discharging state. In the time period in which Q2 is turned off, there is a time segment in which Q6 is in a turn-on state. The time segment includes the midpoint moment in the time period in which Q2 is turned off. L3 in the third phase of buck-boost converter is in a discharging state.

It may be understood that, in the time period in which Q2 is turned on, there is a time segment in which the working circuits of all the buck-boost converters pass through R2. The time segment includes the midpoint moment in the time period in which Q2 is turned on. In the time period in which Q2 is turned off, there is a time segment in which the working circuit of the first phase of buck-boost converter does not pass through R2 and the working circuits of both the second phase of buck-boost converter and the third phase of buck-boost converter pass through R2. The time segment includes the midpoint moment in the time period in which Q2 is turned off. The processing module 51 may obtain the current value of R2 at the first moment and the current value of R2 at the second moment, and determine, as the inductor current value of the first phase of buck-boost converter, the difference between the current value of R2 at the first moment and the current value of R2 at the second moment. The first moment may be the midpoint moment in the time period in which Q2 is turned on, and the second moment may be the midpoint moment in the time period in which Q2 is turned off.

Similarly, it may be learned that, in a time period in which Q4 is turned on, there is a time segment in which the working circuits of all the buck-boost converters pass through R2. The time segment includes a midpoint moment in the time period in which Q4 is turned on. In a time period in which Q4 is turned off, there is a time segment in which the working circuit of the second phase of buck-boost converter does not pass through R2 and the working circuits of both the first phase of buck-boost converter and the third phase of buck-boost converter pass through R2. The time segment includes the midpoint moment in the time period in which Q4 is turned off. The processing module 51 may obtain the current value of R2 at the first moment and the current value of R2 at the second moment, and determine, as an inductor current value of the second phase of buck-boost converter, the difference between the current value of R2 at the first moment and the current value of R2 at the second moment. The first moment may be the midpoint moment in the time period in which Q4 is turned on, and the second moment may be the midpoint moment in the time period in which Q4 is turned off.

Further, the current values of R2 at the midpoint moment in the time period in which Q2 is turned on and at the midpoint moment in the time period in which Q4 is turned on are equal and are a total current of the three phases of buck-boost converters. Therefore, the processing module 51 may obtain the current value of R2 at the second moment, and determine, as the inductor current value of the second phase of buck-boost converter, the difference between the current value of R2 at the first moment and the current value of R2 at the second moment. The first moment may be the midpoint moment in the time period in which Q2 is turned on, and the second moment may be the midpoint moment in the time period in which Q4 is turned off. Therefore, a quantity of sampling times is reduced, and working efficiency is improved.

Similarly, it may be learned that, in a time period in which Q6 is turned on, there is a time segment in which the working circuits of all the buck-boost converters pass through R2. The time segment includes a midpoint moment in the time period in which Q6 is turned on. In a time period in which Q6 is turned off, there is a time segment in which the working circuit of the third phase of buck-boost converter does not pass through R2 and the working circuits of both the first phase of buck-boost converter and the second phase of buck-boost converter pass through R2. The time segment includes a midpoint moment in the time period in which Q6 is turned off. The processing module 51 may obtain the current value of R2 at the first moment and the current value of R2 at the second moment, and determine, as an inductor current value of the third phase of buck-boost converter, the difference between the current value of R2 at the first moment and the current value of R2 at the second moment. The first moment may be the midpoint moment in the time period in which Q6 is turned on, and the second moment may be the midpoint moment in the time period in which Q6 is turned off.

Further, the current values of R2 at the midpoint moment in the time period in which Q2 is turned on and at the midpoint moment in the time period in which Q6 is turned on are equal and are a total current of the three phases of buck-boost converters. Therefore, the processing module 51 may obtain the current value of R2 at the second moment, and determine, as the inductor current value of the third phase of buck-boost converter, the difference between the current value of R2 at the first moment and the current value of R2 at the second moment. The first moment may be the midpoint moment in the time period in which Q2 is turned on, and the second moment may be the midpoint moment in the time period in which Q6 is turned off. Therefore, a quantity of sampling times is reduced, and working efficiency is improved.

Based on the foregoing power supply, this application further provides a current sampling method, including:
When determining, at a first moment, that working circuits of all converters in a multiphase interleaved parallel converter pass through a first sampling resistor, the processing module 51 obtains a first current of the first sampling resistor; obtains a second current of the first sampling resistor at a second moment at which a working circuit of a first phase of converter does not pass through the first sampling resistor and a working circuit of another converter in the multiphase interleaved parallel converter passes through the first sampling resistor; and determines, as an inductor current of the first phase of converter, a difference between the first current of the first sampling resistor and the second current of the first sampling resistor. The first sampling resistor is connected to an output end of the multiphase interleaved parallel converter.

In this embodiment of this application, when the working circuit of the first phase of buck-boost converter passes through the first sampling resistor R1 or R2 at the first moment, and the working circuits of both the second phase of buck-boost converter and the third phase of buck-boost converter pass through the first sampling resistor at the first moment, the processing module 51 determines, as the inductor current value of the first phase of buck-boost converter, the difference between the current value of the first sampling resistor at the first moment and the current value of the first sampling resistor at the second moment.

According to the power supply provided in this application and the current sampling method corresponding to the power supply, it may be ensured that circuit costs of the current sampling apparatus are reduced, and it may also be ensured that direct current sampling support for the multiphase interleaved parallel converter is increased, so that applicability is high.

The foregoing descriptions are merely specific implementations of the present invention, but are not intended to limit the protection scope of the present invention. Any variation or replacement readily figured out by a person skilled in the art within the technical scope disclosed in the present invention shall fall within the protection scope of the present invention. Therefore, the protection scope of the present invention shall be subject to the protection scope of the claims.

## Claims

1. A power supply, wherein the power supply comprises an input power supply, a multiphase interleaved parallel converter, and a current sampling apparatus, the input power supply is configured to supply power to an input end of the multiphase interleaved parallel converter, the multiphase interleaved parallel converter comprises at least two phases of converters that are connected in parallel, the current sampling apparatus is connected to a switching transistor in each phase of converter in the at least two phases of converters that are connected in parallel, the current sampling apparatus comprises a first sampling resistor, the first sampling resistor is connected to the input end or an output end of the multiphase interleaved parallel converter, and the at least two phases of converters that are connected in parallel comprise a first phase of converter; and
the current sampling apparatus is configured to: collect a first current of the first sampling resistor at a first moment, and determine an inductor current of the first phase of converter based on the first current of the first sampling resistor at the first moment, wherein a working circuit of the first phase of converter passes through the first sampling resistor at the first moment.

2. The power supply according to claim 1, wherein a working circuit of another converter in the multiphase interleaved parallel converter does not pass through the first sampling resistor at the first moment; and
that the current sampling apparatus determines an inductor current of the first phase of converter based on the first current of the first sampling resistor at the first moment comprises:
determining the first current of the first sampling resistor at the first moment as the inductor current of the first phase of converter.

3. The power supply according to claim 1, wherein working circuits of all converters in the multiphase interleaved parallel converter pass through the first sampling resistor at the first moment, and the first sampling resistor is connected to the input end of the multiphase interleaved parallel converter; and
that the current sampling apparatus determines an inductor current of the first phase of converter based on the first current of the first sampling resistor at the first moment comprises:
collecting a second current of a second sampling resistor at the first moment, and determining, as the inductor current of the first phase of converter, a difference between the first current of the first sampling resistor at the first moment and the second current of the second sampling resistor at the first moment, wherein the second sampling resistor is connected to the output end of the multiphase interleaved parallel converter, and a working circuit of another converter in the multiphase interleaved parallel converter passes through the second sampling resistor at the first moment.

4. The power supply according to claim 1, wherein working circuits of all converters in the multiphase interleaved parallel converter pass through the first sampling resistor at the first moment, and the first sampling resistor is connected to the output end of the multiphase interleaved parallel converter; and
that the current sampling apparatus determines an inductor current of the first phase of converter based on the first current of the first sampling resistor at the first moment comprises:
collecting a second current of a second sampling resistor at the first moment, and determining, as the inductor current of the first phase of converter, a difference between the first current of the first sampling resistor at the first moment and the second current of the second sampling resistor at the first moment, wherein the second sampling resistor is connected to the input end of the multiphase interleaved parallel converter, and a working circuit of another converter in the multiphase interleaved parallel converter passes through the second sampling resistor at the first moment.

5. The power supply according to claim 1, wherein working circuits of all converters in the multiphase interleaved parallel converter pass through the first sampling resistor at the first moment; and
that the current sampling apparatus determines an inductor current of the first phase of converter based on the first current of the first sampling resistor at the first moment comprises:
collecting a second current of the first sampling resistor at a second moment, and determining, the inductor current of the first phase of converter, a difference between the first current of the first sampling resistor at the first moment and the second current of the first sampling resistor at the second moment, wherein the working circuit of the first phase of converter does not pass through the first sampling resistor at the second moment, and a working circuit of another converter in the multiphase interleaved parallel converter passes through the first sampling resistor at the second moment.

6. The power supply according to claim 1, wherein the current sampling apparatus comprises a sampling module and a processing module, wherein
the sampling module is configured to collect the first current of the first sampling resistor; and
the processing module is configured to: obtain the first current of the first sampling resistor at the first moment, and determine the inductor current of the first phase of converter based on the first current of the first sampling resistor at the first moment.

7. The power supply according to any one of claims 1 to 6, wherein the first phase of converter is any one of an H-bridge converter, a buck converter, a boost converter, and a buck-boost converter.

8. A current sampling method, wherein the current sampling method is applied to a power supply, the power supply comprises an input power supply, a multiphase interleaved parallel converter, and a current sampling apparatus, the input power supply is configured to supply power to an input end of the multiphase interleaved parallel converter, the multiphase interleaved parallel converter comprises at least two phases of converters that are connected in parallel, the current sampling apparatus is connected to a switching transistor in each phase of converter in the at least two phases of converters that are connected in parallel, the current sampling apparatus comprises a first sampling resistor, the first sampling resistor is connected to the input end or an output end of the multiphase interleaved parallel converter, the at least two phases of converters that are connected in parallel comprise a first phase of converter, and the method comprises:
collecting, by the current sampling apparatus, a first current of the first sampling resistor at a first moment at which a working circuit of the first phase of converter passes through the first sampling resistor; and
determining an inductor current of the first phase of converter based on the first current of the first sampling resistor.

9. The method according to claim 8, wherein the determining, by the current sampling apparatus, an inductor current of the first phase of converter based on the first current of the first sampling resistor comprises:
when determining, at the first moment, that a working circuit of another converter in the multiphase interleaved parallel converter does not pass through the first sampling resistor, determining the first current of the first sampling resistor as the inductor current of the first phase of converter.

10. The method according to claim 8, wherein the collecting, by the current sampling apparatus, a first current of the first sampling resistor at a first moment at which a working circuit of the first phase of converter passes through the first sampling resistor comprises:
when determining, at the first moment, that working circuits of all converters in the multiphase interleaved parallel converter pass through the first sampling resistor, collecting the first current of the first sampling resistor, wherein the first sampling resistor is connected to the input end of the multiphase interleaved parallel converter;
the method further comprises:
collecting a second current of a second sampling resistor at the first moment, wherein a working circuit of another converter in the multiphase interleaved parallel converter passes through the second sampling resistor at the first moment, and the second sampling resistor is connected to the output end of the multiphase interleaved parallel converter; and
the determining, by the current sampling apparatus, an inductor current of the first phase of converter based on the first current of the first sampling resistor comprises:
determining, as the inductor current of the first phase of converter, a difference between the first current of the first sampling resistor and the second current of the second sampling resistor.

11. The method according to claim 8, wherein the collecting, by the current sampling apparatus, a first current of the first sampling resistor at a first moment at which a working circuit of the first phase of converter passes through the first sampling resistor comprises:
when determining, at the first moment, that working circuits of all converters in the multiphase interleaved parallel converter pass through the first sampling resistor, collecting the first current of the first sampling resistor, wherein the first sampling resistor is connected to the output end of the multiphase interleaved parallel converter;
the method further comprises:
collecting a second current of a second sampling resistor at the first moment, wherein a working circuit of another converter in the multiphase interleaved parallel converter passes through the second sampling resistor at the first moment, and the second sampling resistor is connected to the input end of the multiphase interleaved parallel converter; and
the determining, by the current sampling apparatus, an inductor current of the first phase of converter based on the first current of the first sampling resistor comprises:
determining, as the inductor current of the first phase of converter, a difference between the first current of the first sampling resistor and the second current of the second sampling resistor.

12. The method according to claim 8, wherein the collecting, by the current sampling apparatus, a first current of the first sampling resistor at a first moment at which a working circuit of the first phase of converter passes through the first sampling resistor comprises:
when determining, at the first moment, that working circuits of all converters in the multiphase interleaved parallel converter pass through the first sampling resistor, collecting the first current of the first sampling resistor;
the method further comprises:
collecting a second current of the first sampling resistor at a second moment at which the working circuit of the first phase of converter does not pass through the first sampling resistor and a working circuit of another converter in the multiphase interleaved parallel converter passes through the first sampling resistor; and
the determining, by the current sampling apparatus, an inductor current of the first phase of converter based on the first current of the first sampling resistor comprises:
determining, as the inductor current of the first phase of converter, a difference between the first current of the first sampling resistor and the second current of the first sampling resistor.

13. The method according to any one of claims 8 to 12, wherein the first phase of converter is any one of an H-bridge converter, a buck converter, a boost converter, and a buck-boost converter.
